Europäisches Patentamt

European Patent Office

Office européen des brevets

(19)

(11) **EP 0 631 395 B1**

(12) **FASCICULE DE BREVET EUROPEEN**

(45) Date de publication et mention
de la délivrance du brevet:
**24.03.1999 Bulletin 1999/12**

(51) Int Cl.⁶: **H03M 3/02**, H03M 1/60,
H03G 3/00

(21) Numéro de dépôt: **94109610.9**

(22) Date de dépôt: **22.06.1994**

(54) **Circuit de traitement de signaux comportant un étage d'entrée à gain variable**

Schaltung zur Verarbeitung von Signalen mit einer Eingangsstufe mit veränderbarer Verstärkung

Signal processing circuitry comprising an input stage with variable gain

(84) Etats contractants désignés:
**AT BE CH DE DK ES FR GB GR IE IT LI LU MC NL PT SE**

(30) Priorité: **28.06.1993 FR 9307950**
**25.03.1994 FR 9403541**

(43) Date de publication de la demande:
**28.12.1994 Bulletin 1994/52**

(73) Titulaire: **CSEM**
**Centre Suisse d'Electronique et de Microtechnique SA**
**2007 Neuchâtel (CH)**

(72) Inventeurs:
• **Nys, Olivier**
**CH-2034 Peseux (CH)**

• **Blumenkrantz, Enrique Marcelo**
**CH-2000 Neuchâtel (CH)**

(74) Mandataire: **de Montmollin, Henri et al**
**ICB**
**Ingénieurs Conseils en Brevets SA**
**Rue des Sors 7**
**2074 Marin (CH)**

(56) Documents cités:
**EP-A- 0 338 837          EP-A- 0 378 777**
**EP-A- 0 488 545          FR-A- 2 300 993**
**US-A- 3 921 012          US-A- 4 851 841**
**US-A- 5 134 401          US-A- 5 187 482**

• **PATENT ABSTRACTS OF JAPAN vol. 14, no. 437 (E-0980) 19 Septembre 1990 & JP-A-02 170 723 (YAMAHA CORP)**

## Description

La présente invention concerne très généralement les circuits de traitement prévus pour produire un signal de sortie variable en réponse à une grandeur variable captée ou reçue en entrée. La présente invention concerne plus particulièrement les circuits de traitement qui sont associés à un étage ou à un capteur d'entrée fournissant un signal avec un facteur d'amplification/atténuation variable, et elle concerne notamment les circuits pour le traitement de signaux en amont de l'entrée desquels est placé un circuit à gain variable.

Il est classique de prévoir un élément à gain commutable, ou plus généralement à gain variable, en amont d'un circuit pour le traitement d'un signal. Tout le monde connaît notamment l'exemple des volt-mètres à commutation de gamme. D'une manière générale, on a normalement recours à une telle association entre un élément à gain commutable et un circuit pour le traitement d'un signal lorsqu'on désire assurer un rapport signal/bruit constant dans une gamme plus étendue que la gamme dynamique propre du circuit de traitement.

L'utilisation d'un étage à gain commutable en amont d'un circuit de traitement de signaux peut présenter des inconvénients. En effet, avec de nombreux types de circuits, chaque commutation de gamme de sensibilité entraînent l'apparition de valeurs ou d'états transitoires indésirables (ci-après désignés par transitoires) dans le signal fourni en sortie. Ces transitoires liées à un changement de gamme apparaissent systématiquement dès qu'un circuit donné comprend des composants comme des condensateurs ou des bobines qui, par nature, accumulent des "souvenirs" d'états antérieurs du circuit. Dans ces conditions, on parle de circuits ayant une mémoire, de circuit dépendant de variables d'état ou encore de circuit dont la caractéristique de transfert dépend de variables d'état.

Le document EP 0 488 545 décrit un filtre pour chaîne Doppler qui produit un signal de sortie variable en réponse à un signal d'entrée d'écho ultrasonore. Le circuit constituant ce filtre correspond au préambule de la revendication 1. Toutefois, ce filtre concerne l'amélioration d'une image à afficher par la suppression des composants fréquentiels non désirés dus à une discontinuité du signal sonore.

On comprendra, qu'avec les circuits dont la caractéristique de transfert dépend de variables d'états ou, en d'autres termes, avec les circuits ayant une mémoire, le recours à la commutation de gammes n'est possible que si on donne au circuit le temps de se stabiliser, après chaque changement de gamme, avant d'utiliser le signal qu'il fournit en sortie.

Les circuits analogiques ayant une mémoire sont très courants. En effet, Les filtres analogiques les plus courants comportent des composants inductifs ou capacitifs qui gardent la mémoire des états antérieurs, D'autre part, les circuits analogiques les plus précis, comme par exemple les convertisseurs sigma-delta ou les systèmes à verrouillage de phase ou de fréquence (Lock-in), sont basés sur un compromis entre d'une part la précision dans la réalisation de leurs différents composants et d'autre part leur temps de réaction ou leur bande passante.

Dans les amplificateurs "Lock-in", en particulier, on met à profit la périodicité connue d'un signal pour réaliser sa détection dans une largeur de bande extrêmement limitée de façon à le distinguer du bruit ambiant. Dans les modulateurs sigma-delta, par contre, une certaine tolérance quant à la précision de réalisation est compensée par le recours au sur-échantillonage et à une rétro-action quantifiée qui prend en compte les erreurs passées jusqu'à un certain ordre.

Afin de permettre une meilleure définition de l'objet de la présente invention, il est utile de mieux caractériser la caractéristique de transfert et les propriétés fonctionnelles des circuits ayant une mémoire.

Les caractéristiques fonctionnelles d'un circuit analogique de traitement sans mémoire peuvent être décrites sous la forme d'une combinaison quelconque (éventuellement très complexe) mais fixe de coefficients constants et de quantificateurs. Cette caractéristique de transfert est alors déterminée, et le signal en sortie du circuit à un instant donné est donc déterminé entièrement par la connaissance du signal instantané en entrée.

Dans le cas d'un circuit analogique ayant une mémoire, en revanche, la valeur du signal en sortie ne dépend pas seulement du signal en entrée à un instant particulier, mais également du signal en entrée à d'autres instants antérieurs à cet instant particulier. On peut dire que dans le cas d'un élément de circuit ayant une mémoire, les souvenirs du circuit influencent ses caractéristiques de transfert. En d'autre termes, dans le cas d'un élément de circuit ayant une mémoire, la combinaison de coefficients et quantificateurs qui permet de déterminer la valeur du signal en sortie à partir de la valeur du signal en entrée à un instant donné, est fonction de la valeur du signal en entrée à des instants antérieurs. Un élément de circuit ayant une mémoire sera donc généralement caractérisé, du point de vue fonctionnel, par une combinaison comprenant des coefficients constants et des quantificateurs, mais auxquels s'ajoutent, cette fois, des éléments variables qui gardent la mémoire des instants antérieurs et sont appelés variables d'état. Notons, en particulier, que dans le cas de filtres analogiques, il y aura autant de variables d'état que de pôles.

On peut donc dire que la mémoire d'un élément de circuit est stockée dans des variables d'état. Dans un circuit réel, les éléments qui emmagasinent cette mémoire sont les capacités et les inductances. Les variables d'état d'un circuit seront donc définies par des ten-sions aux bornes de condensateurs, des courants dans des enroulements ou une combinaison des deux. On remarquera, de plus, que toute capacité placée sur le chemin du signal constitue une forme d'intégrateur et que, en conséquence, on peut dire que la mémoire d'un élément de circuit est emmagasinée dans des intégrateurs.

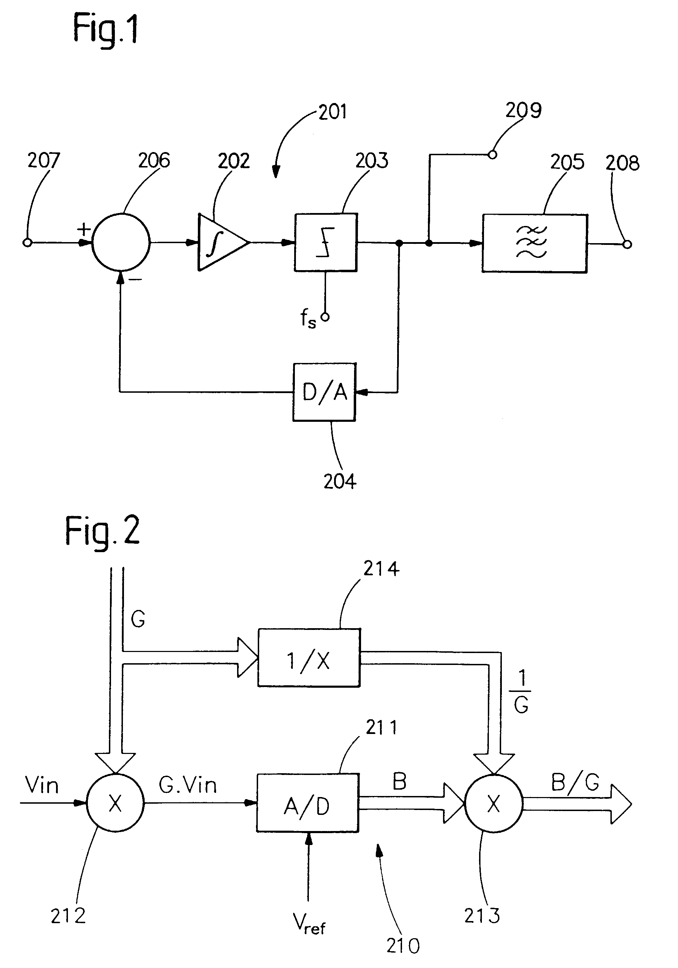

Un exemple particulier d'un circuit ayant une telle mémoire est, comme nous l'avons déjà dit, un convertisseur sigma-delta. Pour permettre d'expliquer les principes de base du fonctionnement d'un convertisseur sigma-delta, on se référera à la figure 1 des dessins annexés sur laquelle on a représenté schématiquement un convertisseur analogique/numérique 201 du type sigma-delta du premier ordre, ce convertisseur comprenant un intégrateur 202, un comparateur 203, un convertisseur numérique/analogique 204 à un seul bit, un filtre numérique passe-bas 205 et un circuit 6 de combinaison de signaux. Le convertisseur A/D 201 comprend également une borne d'entrée 207, une borne de sortie 208 et une borne de données 209.

Un signal d'entrée analogique est appliqué à la borne d'entrée 207 et transmis à l'intégrateur 202 par l'intermédiaire du circuit de combinaison 206. Le comparateur 203 échantillonne le signal provenant de l'intégrateur 202 à une fréquence d'échantillonnage $f_s$ qui est N fois plus élevée que la fréquence $f_N$ de Nyquist ($f_N$ vaut deux fois la fréquence la plus élevée du signal). N est appelé "facteur de suréchantillonnage". Ainsi, des estimations grossières (à 1 bit) du signal analogique d'entrée apparaissent à la sortie du comparateur 3 au rythme du taux de suréchantillonnage. Ces estimations se présentent sous la forme d'un train de bits à la borne de données 209 et elles sont converties sous forme analogique par le convertisseur D/A 204, tout en étant soustraites du signal d'entrée analogique par le circuit de combinaison de signaux 206. Le train de bits provenant de la sortie du comparateur 203 contient de l'information composée de la valeur d'entrée analogique, sous forme numérique, ainsi qu'un signal d'erreur numérique qui est aussi appelé "erreur de quantification" ou "bruit de quantification".

Pour permettre une analyse de l'information contenue dans le train de bits, on peut représenter le convertisseur 1 sous la forme d'un système linéaire dans lequel la sortie du comparateur peut être rendue linéaire sous la forme de y(t) = cx(t) + r(t), expression dans laquelle x(t) est l'entrée du comparateur, y(t) est la sortie de ce dernier et c est le gain linéarisé du comparateur. L'erreur ou le bruit de quantification r(t) représente l'erreur entre le modèle linéaire et le transfert initialement non-linéaire. La sortie du convertisseur apparaissant sur la borne de données 209 peut être exprimée en termes de I(s) et de G(s), qui sont les représentations respectivement du domaine de fréquences du signal d'entrée i(t) appliqué à la borne 207 et de la fonction de transfert d'intégration g(t), et également de R(s) qui est la densité spectrale de l'erreur de quantification r(t) :

$$Y(s) = \frac{(cG(s))}{(1 + cG(s))}.I(s) + \frac{1}{(1 + cG(s))}.R(s)$$

Cette équation montre que l'utilisation d'une fonction de transfert G(s) représentant un intégrateur ou un filtre passe-bas du premier ordre permet de réduire au minimum l'erreur de quantification dans les composantes à basse fréquence du train de bits Y(s). Dans ce cas, pour des fréquences dans la bande de base, une approximation de Y(s) peut être exprimée par l'équation suivante :

$$Y(s) = I(s) + \frac{1}{(1 + cG(s))}.R(s)$$

Par conséquent, I(s) n'est pas déformée et le bruit de quantification R(s) est transféré par un filtre passe-haut $1/_{(1 + cG(s))}$, qui réalise une atténuation maximale de l'erreur de quantification pour des fréquences de la bande de base et également une atténuation qui diminue progressivement pour les fréquences qui se situent au-delà de la bande de base. Ce processus est appelé "mise en forme du bruit". Les erreurs à fréquence plus élevée qui sont contenues dans le train de bits sont supprimées par le filtre numérique passe-bas 205. En outre, la plage dynamique du convertisseur sigma-delta 201 peut être améliorée en utilisant à la place de l'intégrateur 202 représenté à la figure 1, soit un intégrateur de second ordre ou d'un ordre plus élevé, soit un filtre passe-bas de second ordre ou d'un ordre plus élevé, soit encore une suite de deux ou plus de deux intégrateurs ou filtres de ce type.

Un convertisseur de signal à plages multiples comporte au moins deux plages d'entrée dont chacune est définie par une valeur maximale du signal d'entrée, que le convertisseur peut accepter. On a représenté schématiquement un tel convertisseur sur la figure 2 des dessins annexés sous la forme d'un convertisseur analogique/numérique 210 comprenant un circuit classique 211 convertisseur A/D, des circuits 212 et 213 de combinaison de signaux et un circuit inverseur 214. Un signal analogique $V_{in}$ est amplifié par un gain G dans le circuit 212 de combinaison de signaux. Le signal amplifié $G*V_{in}$ est converti en un signal de sortie numérique B par le circuit A/D 211. Le signal de sortie B est ensuite amplifié par l'inverse du gain G dans le circuit 213 de combinaison de signaux. Il en résulte, à la sortie de ce dernier, un signal numérique $B/_G$ représentant le signal d'entrée analogique $V_{in}$.

Les différentes plages du convertisseur 210 correspondent à différentes valeurs du gain G que l'on peut choisir, chaque plage ayant le même nombre de pas de quantification, nombre qui est déterminé par l'algorithme de conversion du circuit A/D 211. C'est pourquoi la grandeur du pas de quantification dans les différentes plages est directement proportionnelle à la valeur maximale du signal d'entrée. Par conséquent, les plages à faible résolution permettent la conversion de signaux, ayant des amplitudes élevées, avec un pas de quantification relativement grand, tandis que les plages à haute résolution permettent la convertion de signaux d'amplitude plus faible mais avec un pas de quantification relativement plus petit.

La précision et la linéarité des convertisseurs directs ou à pondération binaire sont limitées fondamentalement par la tolérance d'adaptation de ses composants de pondération tels que ses transistors, résistances et condensateurs. Pour cette raison, les convertisseurs intégrés directs A/D ne peuvent assurer une précision meilleure que 250 à 1000 ppm, ou en d'autres termes, une résolution numérique de 10 à 12 bits.

Par contre, les convertisseurs indirects ou à interpolation ont une précision relative qui, en raison de l'interpolation qu'ils opèrent par rapport au temps, n'est pas limitée par les tolérances d'adaptation des composants. Par conséquent, on utilise souvent des convertisseurs sigma-delta avec une résolution à 16 bits dans des applications dans lesquelles la résolution et la précision relative sont des facteurs importants.

Cependant, les convertisseurs sigma-delta sont des circuits qui ont une mémoire. C'est pourquoi on n'utilise pas souvent des convertisseurs sigma-delta dans des applications dans lesquelles il faut un convertisseur de signaux ayant des plages d'entrée multiples. Plus précisément, si dans un convertisseur sigma-delta, la plage du signal d'entrée est modifiée, on trouve des transitoires c'est-à-dire du bruit supplémentaire dans le signal de sortie. Ce bruit que l'on appelle "bruit de commutation", provient du fait que lors de l'accomplissement de la fonction d'intégration, l'intégrateur 202 du convertisseur sigma-delta 201 accumule l'erreur de quantification entre le signal d'entrée et le signal de sortie. Si on utilisait donc un convertisseur sigma-delta dans un convertisseur classique à plages multiples, l'erreur de quantification accumulée serait multipliée par le gain G de la plage utilisée à un moment donné. Si alors la plage du convertisseur, c'est-à-dire la valeur de G, était changée, la fonction de l'intégrateur changerait, mais la charge de sa capacité resterait la même.

Par exemple, si au temps $t_1$, le gain devait être changé d'une valeur $G_1$ à une valeur $G_2$, la charge accumulée dans l'intégrateur juste avant le temps $t_1$ représenterait $G_1(\int_{t1}e(t).dt)$, dans laquelle et représente l'erreur de quantification. Juste après le temps $t_1$, la charge accumulée dans l'intégrateur représenterait $G_2(\int_{t1}e(t).dt)$. Toutefois, le fait que la charge de l'intégrateur ne varie pas au temps $t_1$ altère la relation avec le processus d'intégration; ce dont il résulte l'apparition de bruit de commutation ou en d'autres termes de transitoires dans le train de bits produit par l'intégrateur.

Un but de la présente invention est donc de fournir un circuit constituant un modulateur sigma-delta, dont la caractéristique de transfert dépend de variables d'état, qui soit capable de fonctionner en association avec un circuit à gain variable sans que son signal soit perturbé par des transitoires à la suite de chaque changement dudit gain variable.

La présent invention atteint ce but en fournissant un circuit de traitement pour produire un signal de sortie variable en réponse à une grandeur variable captée ou reçue en entrée, ledit circuit de traitement étant associé à un étage ou a un capteur d'entrée fournissant un signal avec un facteur d'amplification/atténuation variable et ledit circuit de traitement présentant en outre des caractéristiques de réponse qui dépendent notamment de variables d'état, ledit circuit comportant des moyens de suppression des transitoires normalement produites par une modification dudit facteur d'amplification/atténuation, lesdits moyens de suppression des transitoires fonctionnant en modifiant la valeur desdites variables d'état en proportion directe de ladite modification du facteur d'amplification/atténuation caractérisé en ce que ledit circuit est un modulateur passe-bande sigma-delta. La présente invention atteint ce but en fournissant un circuit de traitement pour produire un signal de sortie variable en réponse à une grandeur variable captée ou reçue en entrée, ledit circuit de traitement étant associé à un étage ou à un capteur d'entrée fournissant un signal avec un facteur d'amplification/atténuation variable et ledit circuit de traitement présentant en outre des caractéristiques de réponse qui dépendent notamment de variables d'état, caractérisé en ce qu'il comporte des moyens de suppression des transitoires normalement produites par une modification dudit facteur d'amplification/atténuation, lesdits moyens de suppression des transitoires fonctionnant en modifiant la valeur desdites variables d'état en proportion direct de ladite modification du facteur d'amplification/atténuation.

Grâce aux moyens de suppression des transitoires ci-dessus, on peut faire varier le facteur d'amplification/atténuation sans provoquer de transitoires. De plus, grâce à ce facteur d'amplification/atténuation variable, il est possible de réaliser des circuits dont le régime de fonctionnement est toujours proche de l'optimum aussi bien en ce qui concerne le rappport signal/bruit que la consommation d'énergie. Et celà, quel que soit l'intensité de la grandeur captée ou reçue en entrée.

Selon une variante avantageuse de la présente invention, l'invention fournit un circuit de traitement constituant un convertisseur sigma-delta destiné à convertir un signal d'entrée variable en un signal de sortie variable, ce convertisseur comprenant un circuit de combinaison de signaux destiné à additionner le signal de sortie et le signal d'entrée ou à soustraire le signal de sortie du signal d'entrée de manière à produire un signal combiné, un intégrateur destiné à intégrer le signal combiné de manière à produire un signal intégré, l'intégrateur comprenant un circuit de mémorisation d'erreur destiné à mémoriser une grandeur représentant la valeur temporelle dudit signal combiné, un comparateur destiné à comparer ledit signal intégré à au moins un niveau prédéterminé de manière à produire ledit signal de sortie, un circuit de contre-réaction destiné à appliquer audit circuit de combinaison un signal de contre-réaction représentant ledit signal de sortie, un circuit pour amplifier ledit signal d'entrée avec un facteur d'amplification/atténuation prédéterminé, un circuit de réglage de plages destinés à changer ledit facteur d'amplification/atténuation d'une première valeur à au moins une seconde valeur, un circuit pour amplifier ledit signal de sortie par l'inverse dudit facteur d'amplification/atténuation et un circuit de compensation de bruit pour multiplier ladite quantité prédéterminée par le rapport de ladite seconde valeur à ladite première valeur, lorsque ledit facteur d'amplification/atténuation est modifié de ladite première valeur à ladite seconde valeur.

En multipliant, lorsque la plage d'entrée du convertisseur est modifiée, l'erreur de quantification mémorisée dans l'intégrateur par le rapport du nouveau facteur d'amplification/atténuation à l'ancien facteur d'amplification/atténuation, on évite les défauts qui sont introduits par la variable d'état liée au processus d'intégration et qui conduisent à l'apparition du bruit de commutation.

L'invention a également pour objet un circuit traitement constituant un convertisseur sigma-delta destiné à convertir un signal d'entrée variable en un signal de sortie variable, ce convertisseur comprenant un circuit de combinaison de signaux destiné à engendrer un signal combiné résultant de l'addition d'un signal de contre-réaction représentant ledit signal de sortie et ledit signal d'entrée, ou de la soustraction de ce signal de contre-réaction dudit signal d'entrée, un intégrateur destiné à intégrer ledit signal combiné de manière à engendrer un signal intégré, ledit intégrateur comprenant un circuit de mémorisation d'erreur destiné à mémoriser une quantité qui représente la valeur temporelle dudit signal combiné, un comparateur pour comparer le signal intégré à au moins un niveau prédéterminé de manière à engendrer ledit signal de sortie, un circuit de contre-réaction destiné à fournir un signal de contre-réaction qui représente ledit signal de sortie audit circuit de combinaison de signaux, un circuit pour amplifier le signal de sortie par le facteur d'amplification/atténuation de manière à engendrer ledit signal de contre-réaction, et un circuit de réglage de plages pour changer ledit facteur d'amplification/atténuation d'une première valeur à au moins une seconde valeur.

Comme l'erreur de quantification accumulée dans l'intégrateur est indépendante du facteur d'amplification/atténuation de la plage particulière qui a été choisie, l'introduction de bruit de commutation dans le signal de sortie du convertisseur sigma-delta est évitée.

Dautres caractéristiques et avantages de la présente invention apparaîtront à la lecture de la description détaillée qui va suivre, donnée uniquement à titre d'exemple et faite en se référant aux dessins annexés, sur lesquels :

- la figure 1, déjà décrite, montre un schéma simplifié d'un convertisseur sigma-delta connu;
- la figure 2, déjà décrite également, montre un schéma simplifié d'un convertisseur connu à plages multiples;

- la figure 3 est le schéma de principe d'un circuit de traitement d'un signal analogique selon la présente invention associé avec un étage d'entrée à gain (ou facteur d'amplification/atténuation) variable;
- la figure 4 est le shéma d'un filtre continu de deuxième ordre passe-bande/passe-bas qui constitue un exemple de circuit de traitement selon la présente invention;
- la figure 5 représente les moyens de suppression des transitoires qui selon un premier mode de réalisation particulier de la présente invention sont associés à un des deux condensateurs du filtre de la figure 4;
- la figure 6 représente les moyens de suppression des transitoires qui selon un deuxième mode de réalisation particulier de la présente invention sont associés au condensateur 24b du filtre de la figure 4;
- la figure 7 est le schéma de principe d'un circuit de traitement selon la présente invention associé à un capteur capacitif;
- la figure 8 est un schéma simplifié d'un convertisseur sigma-delta analogique/numérique selon l'invention, ce convertisseur présentant plusieurs plages d'entrée;
- la figure 9 est un schéma simplifié d'un convertisseur à boucle ouverte et à suréchantillonnage du type numérique/analogique, ce convertisseur comprenant également plusieurs plages d'entrée;
- la figure 10 est un schéma simplifié d'un convertisseur sigma/delta destiné à convertir un signal numérique à n bits en un signal numérique à m bits;
- la figure 11 montre de façon simplifiée le fonctionnement du convertisseur sigma-delta de la figure 10;
- la figure 12 est un schéma simplifié d'un convertisseur sigma-delta selon la présente invention, destiné à être utilisé dans le convertisseur numérique/analogique de la figure 9;
- la figure 13 montre le schéma d'un autre convertisseur sigma-delta du type analogique/numérique présentant des plages d'entrée multiples, selon la présente invention;
- la figure 14 montre un schéma simplifié d'un autre convertisseur sigma-delta destiné à convertir un signal numérique à n bits en un signal numérique à m bits selon la présente invention;
- la figure 15 est un schéma bloc d'un convertisseur numérique/analogique à suréchantillonnage et à boucle fermée, comprenant un convertisseur sigma-delta selon la présente invention;
- la figure 16 est un schéma simplifié d'un circuit de commande de gain destiné à être utilisé dans un convertisseur sigma-delta selon la présente invention; et
- la figure 17 est un schéma simplifié d'un circuit de commande automatique de gain destiné à être utilisé avec un convertisseur sigma-delta selon la présente invention.

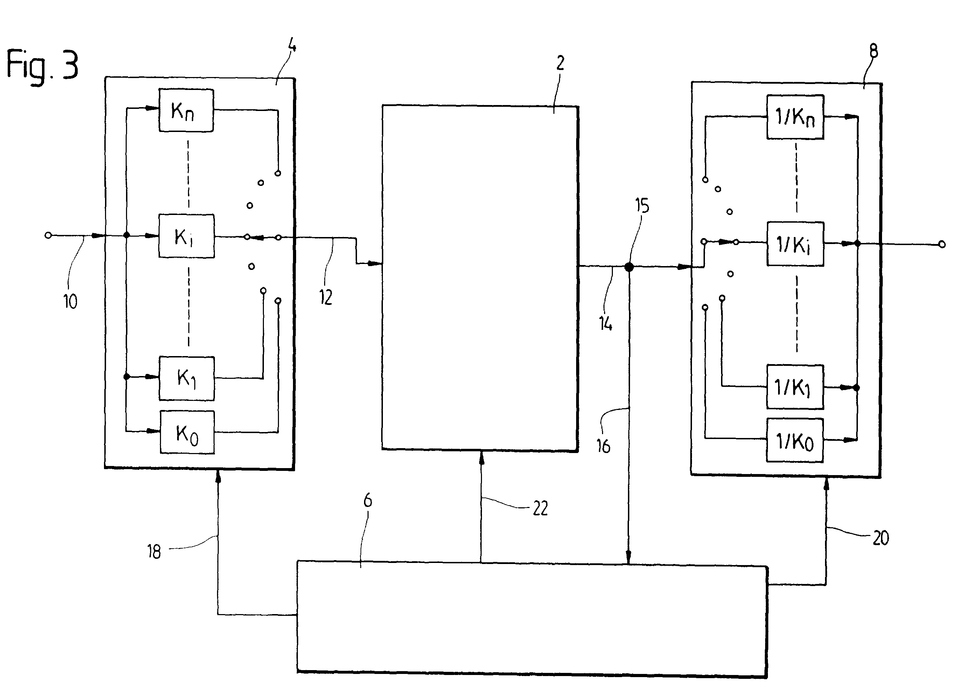

La figure 3 est le schéma de principe d'un circuit analogique selon la présente invention. La figure 3 comporte essentiellement quatre blocs qui symbolisent respectivement un circuit pour traiter un signal 2, un premier étage d'amplification/atténuation à gain variable 4, une bloc 6 regroupant des moyens de commande du gain et des moyens de suppression des transitoires et, finalement, un deuxième étage d'amplification/atténuation à gain variable 8 pour redonner au signal son niveau d'origine. Il convient de noter que dans certaines applications, le bloc 8 peut être implicite. Dans le cas d'un multi-mètre, par exemple, c'est l'opérateur qui détermine l'échelle de mesure à considérer en connaissant la position du sélecteur de gamme.

Le principe général de fonctionnement est le suivant. Le signal à traiter est tout d'abord fourni par une ligne 10 à l'entrée du premier étage d'amplification/atténuation 4 qui, en réponse à ce signal, fournit en sortie sur une ligne 12 un signal dont l'amplitude est normalisée. L'étage d'amplification/atténuation 4 est prévu pour être commandé par les moyens de commande du gain. Sur la figure 3, les différentes valeurs que peut prendre le gain sont notées $K_0$, $K_1$,..., $K_n$. Comme on le verra plus loin, le gain peut prendre soit un ensemble de valeurs discrètes (on parle alors d'un gain commutable), soit varier continûment dans un certain intervalle.

Le signal amplifié par l'étage d'amplification/atténuation est fourni, via la ligne 12, à l'entrée du circuit 2 de traitement du signal. En réponse à ce signal sur son entrée, le circuit 2 fournit en sortie sur une ligne 14 un signal traité. Le traitement apporté au signal peut être de tous les types connus (filtrage, analyse, conversion analogique/numérique, etc.).

On voit encore sur la figure 3 une ligne 16 s'étendant entre un noeud 15 sur la ligne 14 et le bloc 6. Cette ligne 16 sert à appliquer le niveau du signal fourni en sortie du circuit de traitement 2 aux moyens de commande du gain du bloc 6, de façon à permettre à ces derniers de déterminer à quel moment le gain de l'étage 4 doit être changé. L'homme du métier comprendra qu'au lieu de contrôler le niveau du signal en sortie du circuit de traitement 2, il serait également possible de mesurer le niveau du signal en entrée, du signal en sortie du premier étage 4 ou en tout autre endroit du schéma de la figure 3.

Dans l'exemple de la figure 3, le principe de fonctionnement des moyens de commande du gain 6 est le suivant; si à un moment donné le niveau du signal sur la ligne 16 dépasse une certaine fraction, par exemple 90%, de la dynamique totale du circuit 2 ou si, au contraire, ce niveau tombe en dessous d'une certaine fraction, par exemple 25%, de la dynamique, les moyens de commande du gain réagissent en commandant les deux étages d'amplification/atténuation 4 et 8 de manière à changer leur gain, de façon à ramener le niveau du signal en entrée du circuit de traitement 2 à une valeur aussi proche que possible du maximum admissible par ce dernier.

A cet effet, on voit encore sur la figure 3 deux lignes 18 et 20 reliant les moyens de commande du gain 6 aux deux étages d'amplification/atténuation 4 et 8. les deux lignes 18 et 20 sont destinées à fournir à chacun des étages 4 et 8 un signai de commande en réponse auquel chacun des étages 4 et 8 va changer de gain. Les moyens de commande du gain et les étages d'amplification/atténuation sont prévus pour coopérer de façon à ce que, lorsque le gain du premier étage 4 change dans un rapport donné, le gain du deuxième étage 8 change dans un rapport inverse à celui du premier étage. Un tel arrangement est important lorsque par exemple le signal à traiter est un signal audio que l'on désire filtrer. Toutefois, comme on l'a déjà dit, le deuxième étage d'amplification/atténuation 8 peut ne pas être explicitement présent comme dans les instruments de mesure déjà mentionnés.

Les éléments de la figure 3 dont le fonctionnement a été décrit jusqu'ici sont connus de l'homme du métier et peuvent être réalisés selon un grand nombre de variantes, et le champ d'application des moyens du suppression des transitoires selon la présente invention, qui vont maintenant être décrits, ne se limite absolument pas à la variante particulière représentée sur la figure 3.

En l'absence des moyens de suppression des transitoires selon la présente invention, si le circuit de traitement d'un signal 2 a une mémoire, son fonctionnement est perturbé chaque fois que le gain de l'étage d'amplification est modifié. Toute commutation du gain produit des transitoires dans le signal de sortie qui rendent ce dernier inutilisable jusqu'à ce que le circuit 2 se soit stabilisé. Dans le cas où le gain du premier étage 4 varie progressivement, on n'observe pas de transitoires à proprement parler dans le signal de sortie mais ce signal contient toutefois une composante indésirable produite par les variations du gain du premier étage 4.

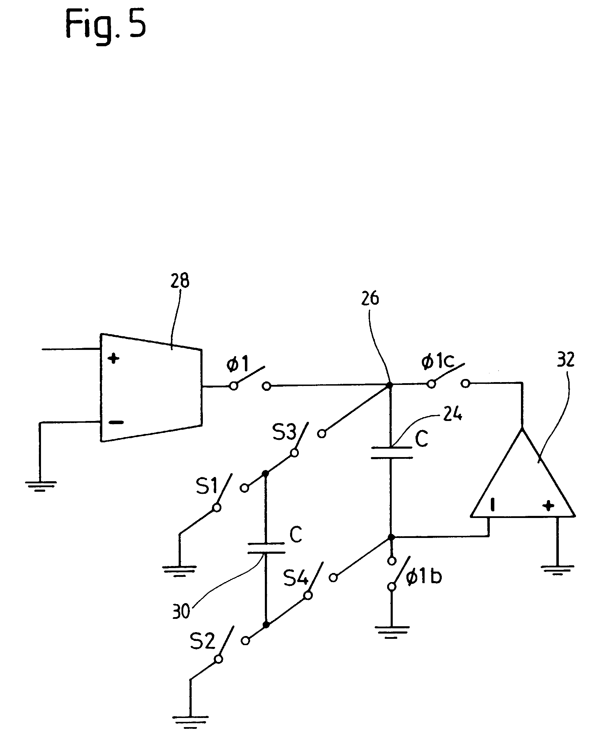

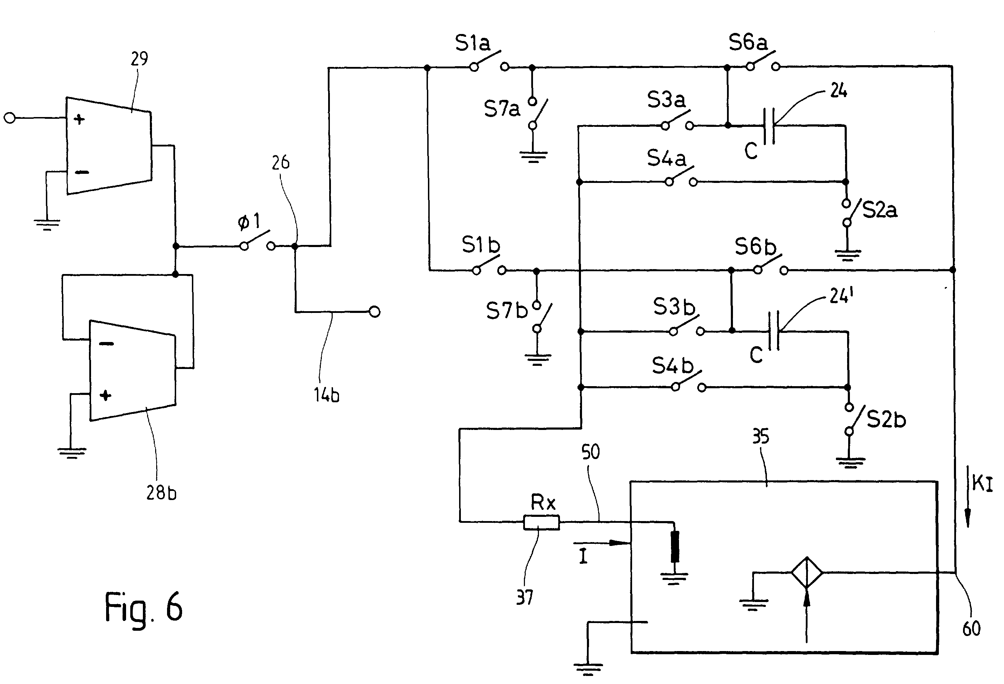

Pour remédier à cet état de fait, le module 6 de la figure 3 comprend encore, selon la présente invention, un séquenceur qui est associé aux moyens de commande du gain, et qui assure, via la ligne 22, la commande des moyens de suppression des transitoires selon la présente invention. Ces moyens de suppression des transitoires seront décrit plus en détail plus loin en relation avec les figures 5 et 6.

Comme on l'a déjà dit dans le préambule de cette description, les moyens de suppression des transitoires sont prévus de manière à modifier les valeurs des variables d'état du circuit de traitement 2 chaque fois que le gain de l'étage d'amplification/atténuation 4 change. De plus. la modification des variables d'état est faite en proportion de la variation du gain du premier étage 4. L'expérience montre, en effet, qu'une telle modification des variables d'état permet de faire disparaître presque entièrement les transitoires et les composantes indésirables dans le signal de sortie du circuit de traitement 2.

Bien que le principe de la présente invention ait déjà été exposé ci-dessus, nous n'avons pas, jusqu'ici, décrit le fonctionnement exact qui permet aux moyens de suppression des transitoires de modifier de façon adéquate les valeurs des variables d'état du circuit de traitement 2. En effet, la forme particulière dans laquelle sont réalisés les moyens de suppression des transitoires dépend de la nature particulière du circuit de traitement 2. Nous allons maintenant décrire, en nous référant à deux exemples particuliers de circuit comportant une mémoire, deux modes particuliers de réalisation des moyens de suppression des transitoires selon la présente invention.

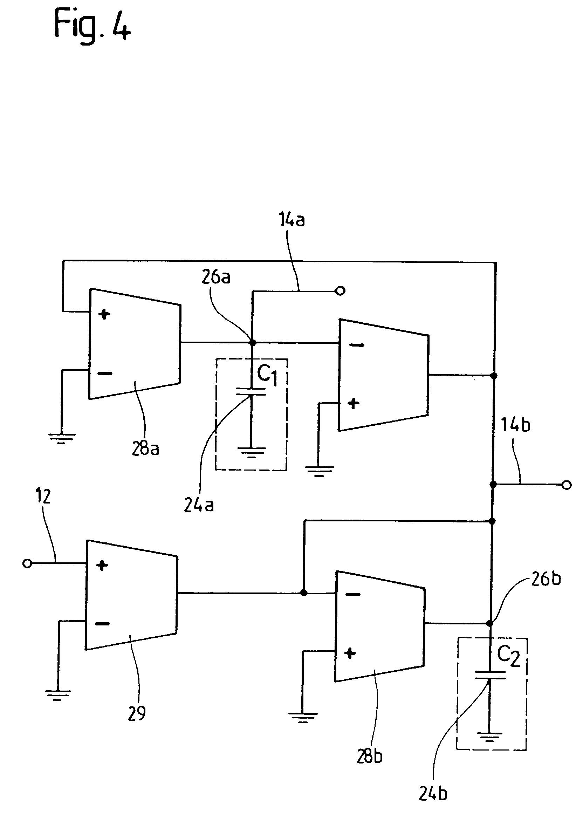

Le circuit représenté schématiquement sur la figure 4 constitue un premier exemple particulier de circuit pour le traitement d'un signal qui est figuré généralement sur la figure 3 par le bloc référencé 2. Le schéma de la figure 4 représente un filtre continu de deuxième ordre passe-bande/passe-bas utilisant des amplificateurs opérationels à transconductance et des capacités (OTA-C). Ce type de filtre est connu de l'homme du métier. En effet, il est largement utilisé dans des réalisations intégrées analogiques, pour le traitement de signaux.

Le circuit de la figure 4 comporte une ligne d'entrée 12 pour recevoir un signal à filtrer fourni par le premier étage d'amplification/atténuation (figure 3) et deux lignes de sortie 14a et 14b destinées à être utilisées alternativement pour fournir soit un signal filtré en passe-bas, soit un signal filtré en passe-bande.

On voit sur la figure 4 que le circuit 2 comprend deux condensateurs, de capacité C1 et C2 respectivement, référencés 24a et 24b. Ces condensateurs 24a et 24b sont connectés, chacun, entre un noeud du circuit (référencé respectivement 26a et 26b) et la masse. Comme on le voit sur la figure, les noeuds 26a et 26b sont chacun situés en aval d'un amplificateur (référencés respectivement 28a et 28b). On comprendra du préambule de la description que, dans le circuit représenté ici, ce sont les condensateurs 26a et 26b qui emmagasinent la mémoire du circuit. En conséquence, dans le présent exemple, les variables d'état qui doivent, conformément à la présente invention, être modifiées par les moyens de suppression des transitoires sont les charges respectives des deux condensateurs susmentionnés.

La figure 5 représente un des condensateurs 24a ou 24b de la figure 4 avec les moyens de suppression des transitoires qui, selon la présente invention, lui sont associés.

Les éléments de la figure 5 qui étaient déjà représentés sur la figure 4 conservent les mêmes numéros de référence. Plus précisément, le condensateur 24 de capacité C représente l'un des condensateurs 24a ou 24b, le noeud 26 représente l'un des noeuds 26a ou 26b et l'amplificateur à transconductance 28 représente l'un des amplificateurs à transconductance 28a ou 28b.

Les autres éléments représentés sur la figure 5 font partie des moyens de suppression des transitoires selon la présente invention. Les moyens particuliers de suppression des transitoires décrits dans ce premier exemple sont prévus pour une situation où l'amplitude du signal en entrée du circuit de la figure 4 a préalablement été normalisé par un étage d'amplification/atténuation, dont le gain peut prendre différentes valeurs discrètes ayant entre elles des rapports qui sont des puissances de 2. Dans le présent exemple, ces moyens comportent un condensateur 30, ayant la même capacité C que le condensateur 24, un amplificateur opérationnel 32 et sept interrupteurs référencés, respectivement, Ø1, Ø1b, Ø1c, S1, S2, S3 et S4.

Comme l'homme du métier l'aura reconnu, le montage décrit dans la figure 5 est un montage du type à capacités commutées. Les interrupteurs peuvent être commandés par des signaux de commandes engendrés de façon classique par un séquenceur (déjà mentionné en relation avec la figure 3) répondant lui-même aux signaux de commande produits par les moyens de commande du gain (référencés 6 sur la figure 3). Les signaux de commande, engendrés par le séquenceur, sont fournis aux différents interrupteurs par des lignes de transmission non représentées.

Les moyens de suppression des transitoires sont donc prévus pour modifier les valeurs des variables d'état par une puissance quelconque de 2. Nous allons d'abord décrire la séquence des commutations qui permettent de diviser par 2 la tension entre les bornes du condensateur 24. Pour diviser la tension entre les bornes du condensateur 24 par une puissance de 2 supérieure à un, il suffit de répéter le processus de division par 2 autant de fois que nécessaire.

Lorsque les moyens de supppression des transitoires selon la présente invention sont inactifs ou, en d'autre termes, lorsque le gain de l'étage d'amplification/atténuation situé en amont du filtre ne change pas, les interrupteurs Ø1 et Ø1b sont fermés alors que tous les autres interrupteurs sont ouverts.

A l'instant où les moyens de commande du gain envoient un signal de commande pour réduire le gain d'un facteur 2, le séquenceur, commandant les moyens de suppression des transitoires, devient opérant. Il engendre tout d'abord un premier signal de commande pour ouvrir les interrupteurs Ø1 eT Ø1b et pour fermer l'interrupteur Ø1c et les interrupteurs S1 et S2. Le premier résultat de ces commutations est d'isoler le premier condensateur 24 et son contenu du reste du circuit. De plus, la fermeture de l'interrupteur Ø1c a pour effet de connecter le condensateur 24 entre la sortie et la masse virtuelle de l'amplificateur 32 de sorte que sa charge est, dans un premier temps, maintenue constante. Finalement, la fermeture des interrupteurs S1 et S2 à pour effet de décharger complètement le deuxième condensateur 30.

Ensuite, le séquenceur envoie un deuxième signal de commande pour ouvrir les interrupteurs Ø1c,

S1 et S2 et fermer les interrupteurs S3 et S4 de façon à connecter les deux condensateurs 24 et 30 en parallèle. Dans ces conditions, la moitié de la charge présente dans le condensateur 24 passe dans le condensateur 30 pour égaliser les tensions entre les bornes des deux condensateurs. Ce transfert de charge a pour effet de diviser par 2 la valeur de la variable d'état stockée dans le condensateur 24. Le séquenceur envoie finalement un troisième signal de commande pour remettre les interrupteurs dans leur configuration initiale (tous les interrupteurs ouverts sauf $\emptyset$1 et $\emptyset$1b).

Nous allons maintenant décrire la séquence de commutations utilisée pour doubler la tension entre les bornes du condensateur 24. Comme nous l'avons déjà dit, en l'absence d'un changement du gain, les interrupteurs $\emptyset$1 et $\emptyset$1b sont fermés et tous les autres interrupteurs sont ouverts.

A l'instant où les moyens de commande du gain envoient un signal de commande pour augmenter le gain d'un facteur 2, le séquenceur commandant les moyens de suppression des transitoires devient opérant. Il engendre tout d'abord un premier signal de commande identique au premier signal de commande de la séquence de division par 2 décrite plus haut. Ce signal de commande a pour effet d'ouvrir les interrupteurs $\emptyset$1 et $\emptyset$1b et de fermer l'interrupteur $\emptyset$1c. Comme nous l'avons déjà dit, le premier résultat de cette commutation est d'isoler le condensateur 24 et son contenu du reste du circuit. De plus, la fermeture de l'interrupteur $\emptyset$1c a pour effet de connecter le condensateur 24 entre la sortie et la masse virtuelle de l'amplificateur 32 de sorte que sa charge est, dans un premier temps, maintenue constante.

Ensuite, le séquenceur envoie un deuxième signal de commande pour fermer les interrupteurs S2 et S3. Dans ces conditions, l'amplificateur opérationel 32 charge le condensateur 30 jusqu'à ce que la tension entre ses bornes soit égale à la tension entre les bornes du condensateur 24. La capacité du condensateur 30 étant identique à celle du condensateur 24, il contiendra la même charge que ce dernier.

Le séquenceur envoie ensuite un troisième signal de commande pour ouvrir les interrupteurs S2 et S3 et fermer les interrupteurs S1 et S4. Dans ces conditions, les charges contenues dans le condensateur 30 provoquent une modification du potentiel au niveau de l'entrée inverseuse de l'amplificateur 32 qui, en réponse, fournit des charges au condensateur 24 jusqu'à ce que le potentiel de son entrée inverseuse soit de nouveau celui de la masse. Cette dernière opération résulte dans un doublement de la tension entre les bornes du condensateur 24. Le séquenceur envoie finalement un quatrième signal de commande pour remettre les interrupteurs dans leur configuration initiale (tous les interrupteurs ouverts sauf $\emptyset$1 et $\emptyset$1b).

Comme on peut s'en rendre compte, dans les cas où, comme dans l'exemple du circuit qui vient d'être décrit, les variables d'état à modifier sont des tensions entre les bornes de condensateurs, il est possible d'avoir recours à une technique de commutation de capacités. Lorsqu'on a recours à une telle technique, le fonctionnement des moyens de suppression des transitoires selon l'invention peut être résumé comme suit:

- à l'instant où un changement de gamme va se produire, découpler tous les composants ayant une mémoire du reste du circuit,
- ensuite changer de façon appropriée la valeur des variables d'état
- finalement, une fois que le changement de gain à l'entrée du circuit est accompli, reconnecter les composants à mémoire au reste du circuit.

Une séquence de commutations comme celle qui vient d'être énoncée peut être effectuée dans un temps beaucoup plus court que la durée des perturbations transitoires qu'on observe en l'absence des moyens de suppression des transitoires selon l'invention. Dans les cas très fréquents où la bande passante du circuit de traitement est suffisamment limitée vers le haut, la coupure produite dans le signal par les moyens de suppression des transitoires pourra même être imperceptible. Dans le cas particulier où le signal à traiter se présente sous la forme d'une modulation d'une porteuse, le changement des variables d'état peut être effectué à l'intérieur d'une ou de plusieurs périodes de la porteuse.

Le mode de réalisation décrit ci-dessus est limité à des modifications de la valeur d'une variable d'état par une puissance de 2. On va maintenant décrire un mode de réalisation des moyens de suppression des transitoires selon la présente invention également apte à être utilisé avec le circuit de la figure 4, mais permettant de changer les valeurs des variables d'état d'un facteur quelquonque compris dans un certain intervalle.

La figure 6 représente donc un deuxième mode de réalisation des moyens de suppression des transitoires selon la présente invention. Dans le présent exemple, les moyens de suppression des transitoires sont utilisés pour changer la valeur de la variable d'état associée au condensateur 24b de capacité C2 de la figure 4. Les composants représentés sur la figure 6 qui figurent déjà sur la figure 4 portent les mêmes numéros de référence.

Le circuit de la figure 6 fonctionne grâce à un bloc 35 fournissant en sortie un courant dont l'intensité est égal au produit de l'intensité du courant en entrée par l'amplitude d'un signal de commande. Ce bloc 35 est adapté pour, d'une part, fournir sur sa sortie 60 un courant KI qui est égal à K fois le courant I reçu sur son entrée 50 et, d'autre part, pour assurer que l'entrée 50 reste à la masse. Ce bloc 35 peut être réalisé à la manière présentée à ISCAS 1989 par Adel S. Sedra sous le titre "the current conveyor; history and progress", et en utilisant un miroir de courant à rapport variable.

Le principe de fonctionnement de ces moyens de suppression des transitoires est simple. Ils comportent deux condensateurs identiques, un premier des deux (par exemple le condensateur 24) remplissant à un moment donné la fonction du condensateur 24b dans le circuit de la figure 4. Lorsqu'on désire modifier la valeur de la variable d'état par un facteur quelconque donné, on décharge le premier condensateur à travers le bloc 35. Le bloc 35 fournit alors, en sortie, une courant dont l'intensité est égale à l'intensité du courant produit par la décharge du premier condensateur multipliée par un facteur K donné. Le courant en sortie du bloc 35 est utilisé pour charger le deuxième condensateur qui, à la fin de l'oppération, présente entre ses bornes une tension égale à la tension qui éxistait préalablement entre les bornes du premier condensateur multipliée par ledit facteur donné. Une fois cette opération terminée, une commutation permet de coupler le condensateur 24' au circuit dans la position qu'occupait initialement le condensateur 24.

Outre les deux condensateurs identiques référencés 24 et 24' et le bloc 35, le circuit de la figure 6 comporte un interrupteur Ø1 qui correspond à l'interrupteur φ1 de la figure 5 et une série de paires d'interrupteurs S1a, S1b, S2a, s2b, S3a, S3b, S4a, S4b, S6a, S6b, S7a et S7b. Le condensateur 24 est associé aux interrupteurs Sa alors que le condensateur 24' est associé aux interrupteurs Sb. Une résistance 37 est finalement montée en entrée du multiplicateur 35 pour freiner la décharge du condensateur lors de la modification de la valeur de la variable d'état.

En l'absence d'un changement de gain de l'étage d'amplification/atténuation, l'interrupteur Ø1 est fermé. Nous supposerons ici qu'avant le changement de gain, c'est le condensateur 24 qui était relié au filtre, Dans ces conditions, l'interrupteur S1a est fermé et l'interrupteur S1b est ouvert. De plus les interrupteurs S3a, S4a, S6a et S7a sont également ouverts alors que l'interrupteur S2a est fermé. Notons encore que les interrupteurs S2b et S7b sont fermés pour maintenir le condensateur 24' entièrement déchargé et que les interrupteurs S3b, S4b et S6b sont ouverts.

A l'instant où les moyens de commande du gain envoient un signal de commande pour modifier le gain d'un facteur donné, le séquenceur commandant les moyens de suppression des transitoires devient opérant. Il engendre, d'une part, une premier signal de commande pour ouvrir l'interrupteur Ø1 et découpler le condensateur 24 du reste du circuit et d'autre part il transmet au bloc 35 un signal correspondant au facteur donné par lequel le gain en entrée du filtre va être multiplié.

Puis les interrupteurs S4a, S7a, S2b et S6b sont fermés alors que l'interrupteur S2a est ouvert. Dans ces conditions, le condensateur 24 va se décharger à travers la résistance 37 dans l'entrée du bloc 35. De plus, tout le courant fourni en sortie du multiplicateur 35 va s'accumuler dans le condensateur 24'. On comprendra que, dans ces conditions, la charge qui va s'accumuler dans le condensateur 24' sera proportionelle à la charge que contenait initialement le condensateur 24. De plus, le facteur K de multiplication du bloc 35 étant déterminé par le facteur par lequel les moyens de commande du gain modifie le gain, le rapport entre la charge du condensateur 24' et de celle du condensateur 24 sera égal au facteur par lequel le gain est changé.

Une fois cette opération accomplie, le séquenceur envoie un signal de commande pour fermer l'interrupteur S1b et fermer l'interrupteur 1 de façon à coupler le condensateur 24' avec le circuit.

Précisons finalement, qu'avec ce dernier mode de réalisation, il est nécessaire de prévoir dans la logique commandant les moyens de suppression des transitoires un moyen pour mémoriser lequel des deux condensateurs 24 et 24' est couplé avec le circuit à un moment donné. En effet la séquence de signaux de commande produite par le séquenceur au moment d'un changement de gain n'est pas la même selon que c'est le condensateur 24 ou le condensateur 24' qui est couplé au circuit.

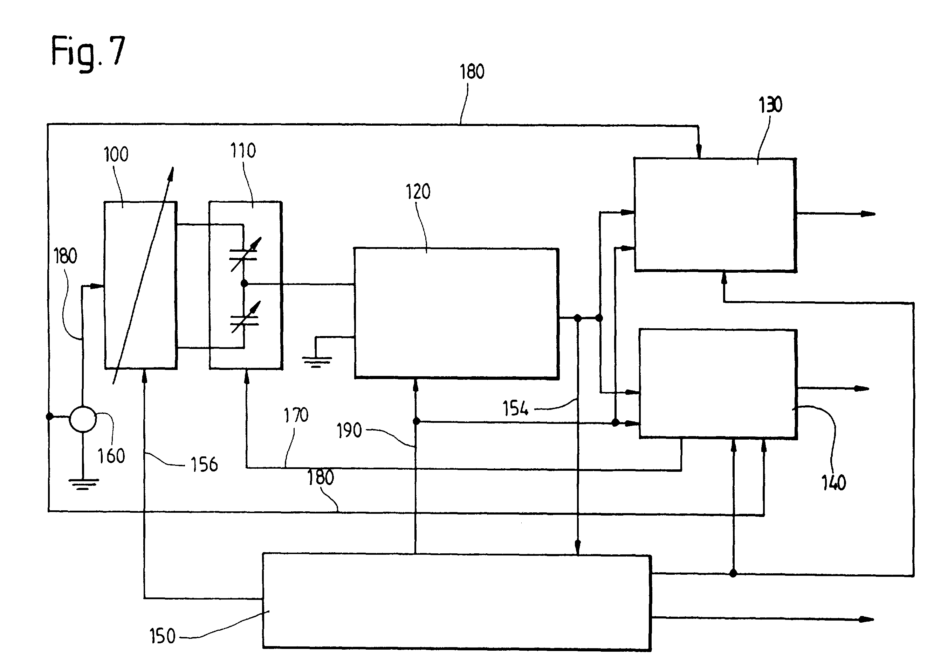

La figure 7 montre un autre exemple d'application de la présente invention. Le dispositif représenté de façon schématique sur la figure 7 est prévu pour fournir en sortie un signal variable en réponse à une grandeur variable captée en entrée par un capteur qui dans le présent exemple est de type capacitif.

En se référant à la figure 7, on voit que le dispositif comporte tout d'abord un capteur capacitif à deux condensateurs 110. La sortie du capteur 110 est reliée à l'entrée d'un circuit de traitement et d'interface 120 qui peut typiquement être constitué par un modulateur Sigma-Delta passe-bande. Le modulateur Sigma-Delta 120 fournit un train de bits modulé en densité d'impulsions. Ce train de bits est fourni à un module de détection synchrone numérique 130 piloté par un signal base de temps fourni sur une ligne 180 par une horloge 160. Le module 130 fournit en réponse un signal numérique qui constitue le signal de sortie du dispositif. Le train de bits produit par le circuit de traitement 120 est également fourni à un module 140 qui fonctionne essentiellement comme un filtre passe-bas pour produire un signal de sortie analogique à partir du signal modulé en densité d'impulsions. Dans l'exemple représenté sur la figure 7, le signal analogique produit par le module 140 est encore transmis par une ligne 170 au capteur 110 de manière à constituer une boucle de rétroaction pour, par exemple, maintenir le capteur dans un état d'équilibre.

Le capteur capacitif 110 peut, de façon connue, être du type comprenant deux condensateurs et dans lequel une lame conductrice mobile constitue une armature mobile commune pour les deux condensateurs. Avec un tel arrangement, tout déplacement de la lame mobile se traduit par une variation des capacités respectives des deux condensateurs. Cette variation des capacités des deux condensateurs est mesurée typiquement en plaçant respectivement les armatures fixes des deux condensateurs à deux potentiels imposés de même valeur mais de signes opposés, et en mesurant soit la charge soit le potentiel sur la lame mobile. Il est a noter qu'avec un tel arrangement l'intensité du signal de mesure, ou autrement dit la sensibilité du capteur, est proportionnelle au module du potentiel imposé aux armatures fixes.

Les dispositifs correspondant à la partie du schéma fonctionnel de la figure 7 qui a été décrite jusqu'ici peuvent être réalisés avec des éléments connus. Un exemple particulier d'un tel dispositif est le dispositif de mesure d'une force décrit dans le document EP 0 590 658. Toutefois, il pourrait être particulièrement avantageux d'utiliser un modulateur tel que celui décrit dans l'article intitulé "A Fourth-Order Bandpass Sigma-Delta Modulator" de Stephen A. Jantzi et al. et paru dans la revue IEEE Journal of Solid-State Circuits, Vol. 28, No. 3, March 1993.

Pour permettre d'utiliser le dispositif qui vient d'être décrit dans des conditions où la dynamique du capteur 110 est plus étendues que la gamme dynamique propre du circuit de traitement 120, il est possible d'avoir recours à une technique de variation commandée de la sensibilité du capteur. Cette technique correspond tout à fait à la technique de variation commandée du gain décrite en relation avec l'exemple de la figure 3. Pour faire varier la sensibilité du capteur capacitif, il suffit, conformément à ce qu'on a déjà dit, de faire varier la tension imposée sur les armatures fixes du capteur.

A cet effet, le dispositif de la figure 7 comporte encore un module 150 qui remplit les mêmes fonctions que les moyens représentés par le bloc 6 sur la figure 3. Le module ou bloc 150 contrôle le niveau en sortie du circuit de traîtement 120 à l'aide de la ligne 154 de manière à déterminer à quel moment la sensibilité du capteur 110 doit être changée. On voit encore sur la figure 7 une ligne de commande 156 qui permet au bloc 150 de commander un bloc 100 qui est prévu pour fournir les deux potentiels de référence pour les armatures fixes du capteur capacitif 110.

Si le circuit de traitement 120 comporte une mémoire, les variations provoquées de la sensibilité du capteur vont, comme dans le cas du dispositif de la figure 3, provoquer l'apparition de transitoires. Selon la présente invention, le dispositif de la figure 7 comprend des moyens de suppression des transitoires (symbolisés par la ligne 190) qui peuvent être réalisés de manière tout à fait analogue à ceux qui ont été décrit en faisant référence à la figure 5 ou à la figure 6.

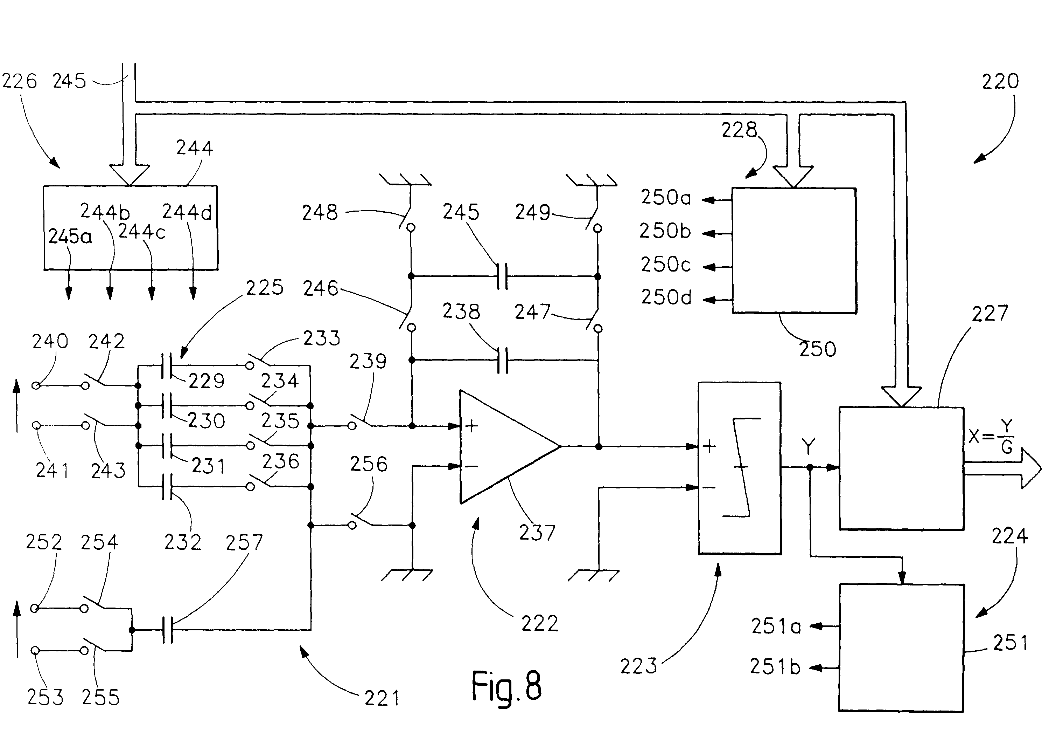

En se référant maintenant à la figure 8, on voit qu'elle représente un convertisseur sigma-delta 220 à plages multiples comprenant un circuit 221 de combinaison de signaux, un intégrateur 222, un comparateur 223, un circuit de contre-réaction 224, un amplificateur 225 du signal d'entrée, un circuit 226 de réglage de plages, un amplificateur 227 du signal de sortie Y et un circuit 228 de compensation de bruit. L'amplificateur 225 de signal d'entrée comprend quatre condensateurs 229, 230, 231 et 232. L'une des armatures des condensateurs 229, 230, 231 et 232 est connectée respectivement à l'une des bornes des interrupteurs 233, 234, 235 et 236.

L'intégrateur 222 comprend un amplificateur opérationnel 237 dont un condensateur 238 est connecté entre son entrée inverseuse et sa sortie. L'intégrateur 222 engendre, à sa sortie, une tension analogique qui représente l'intégration par rapport au temps de la charge totale emmagasinée par les condensateurs 229 à 232 et 257. Les autres bornes des interrupteurs 233, 234, 235 et 236 sont connectées ensemble à l'entrée inverseuse de l'amplificateur opérationnel 237 par l'intermédiaire d'un interrupteur 239. Deux bornes 240 et 241 sont connectées à l'amplificateur 225 de signal d'entrée par l'intermédiaire de deux interrupteurs 242 et 243 de manière qu'une tension analogique $V_{in}$ présente à ces bornes puisse être appliquée sur l'un ou plusieurs des condensateurs 229, 230, 231 et 232. De préférence, les condensateurs 229, 230, 231 et 232 ont la même valeur $C_{in}$.

Le circuit 226 de réglage de plages comprend un circuit 244 de commande d'interrupteurs et les interrupteurs 233, 234, 235 et 236. Un bus de données 245 transmet un signal qui représente le gain G désiré du signal d'entrée du convertisseur sigma-delta 220, au circuit 244 de commande d'interrupteurs. Ce circuit présente quatre sorties 244a, 244b, 244c et 244d pour respectivement commander le fonctionnement des interrupteurs 233, 234, 235 et 236. Le fonctionnement des interrupteurs 233, 234, 235 et 236 est commandé respectivement en fonction du signal de gain reçu du bus 245, de manière que l'on puisse appliquer la tension d'entrée $V_{in}$ présente entre les bornes 240 et 241 sur l'un des condensateurs 229, 230, 231 et 232 ou sur une combinaison de ces condensateurs connectés en parallèle. La charge $Q_{in}$ emmagasinée entre les armatures de la combinaison des condensateurs connectés en parallèle, peut être ainsi égale à $C_{in}*V_{in}$, $2C_{in}*V_{in}$, $3C_{in}*V_{in}$ or $4C_{in}*V_{in}$, en fonction de l'amplification souhaitée du signal d'entrée.

Un autre condensateur 245 est connecté en parallèle au condensateur 238 par l'intermédiaire de deux interrupteurs 246 et 247. Les deux armatures du condensateur 245 sont également reliées à une borne de masse appropriée par l'intermédiaire de deux autres interrupteurs 248 et 249. Le circuit 228 de compensation de bruit comprend un circuit 250 de commande d'interrupteurs et de détection de gain destiné à détecter une variation de la valeur du signal de gain provenant du bus 245 et à commander le fonctionnement respectif des contacteurs 246, 247, 248 et 249 par l'intermédiaire de ses sorties 250a, 250b, 250c et 250d, de manière que les condensateurs 238 et 245 soient connectés, soit en parallèle, soit en série entre l'amplificateur opérationnel 237 et la masse.

Le comparateur 223 compare le niveau de tension à la sortie de l'amplificateur opérationnel 237 avec une tension de référence prédéterminée, qui est dans le cas représenté, le potentiel de la masse. Si la tension de sortie de l'amplificateur opérationnel est supérieure à zéro volt, le comparateur produit un bit de valeur +1 à sa sortie, tandis que lorsque cette tension est inférieure à zéro volt il produit un bit de valeur -1. Dans le train de bits de données, portant la référence Y, qui est ainsi produit par le comparateur 223, la densité des bits de niveau logique haut par rapport à celle des bits de niveau logique bas, représente la tension $V_{in}$ d'entrée analogique appliquée entre les bornes 240 et 241.

Le circuit de contre-réaction 224 comprend un détecteur de bits et un circuit 251 de commande d'interrupteurs, deux bornes 252 et 253, des interrupteurs 239, 254, 255 et 256, un condensateur 257 ayant une valeur $C_{ref}$ et une source de tension $V_{ref}$ (non représentée). Le circuit de commande 251 comporte des sorties 251a et 251b pour permettre la commande des interrupteurs 254 et 255, respectivement. Les interrupteurs 254 et 255 permettent de changer le condensateur 257 avec une charge Qref égale à $C_{ref}*V_{ref}$, ou de décharger ce condensateur. En fonction de la valeur +1 ou -1 du bit produit à la sortie du comparateur 223, la charge $Q_{ref}$ est intégrée dans le sens positif ou dans le sens négatif. La différence entre les charges $Q_{in} \pm Q_{ref}$ est ainsi emmagasinée entre les armatures du condensateur 238 et intégrée de façon correspondante par l'amplificateur opérationnel 237.

Enfin, l'amplificateur 227 de signal de sortie comprend un circuit logique destiné à multiplier l'information numérique contenue dans le train de bits Y engendré à la sortie de comparateur 223 par l'inverse du gain G provenant du bus 245. Le mot numérique, qui porte la référence X, qui résulte de ce calcul est fourni à la sortie du circuit logique 227.

La stabilité du convertisseur sigma-delta 220 est garantie tant que la charge $Q_{in}$ associée au signal d'entrée est inférieure à la valeur absolue de la charge $Q_{ref}$ injectée par contre-réaction. Cette condition détermine la plage d'entrée du convertisseur sigma-delta 220, la tension maximale admissible du signal d'entrée étant donnée sous forme d'une valeur absolue par $V_{in\text{-}max} = V_{ref}*(C_{ref}/N*C_{in})$, où N est le nombre de condensateurs aux bornes desquels la tension d'entrée $V_{in}$ est appliquée pour une plage prédéterminée. Le signal d'entrée $V_{in}$ peut ainsi être échantillonné avec un gain de 1, 2, 3 ou 4 en commandant les interrupteurs 233, 234, 235 et 236 de manière à choisir le nombre correspondant de condensateurs 229, 230, 231 ou 232.

Dans ce mode de réalisation de l'invention, la multiplication du signal d'entrée par un gain prédéterminé est réalisée grâce à la programmation du gain de la branche d'entrée du convertisseur sigma-delta. De façon avantageuse, dans ce mode de réalisation, la consommation de la boucle sigma-delta est, en première approximation, indépendante du gain choisi. La consommation du convertisseur 220 est liée directement à la charge $Q_{ref}$ injectée par contre-réaction qui est indépendante du gain choisi. De même, l'excursion de l'intégrateur est indépendante du gain choisi et il peut donc être choisi à une valeur optimale pour toutes les plages du signal d'entrée du convertisseur 220.

Il est clair que dans d'autres modes de réalisation de l'invention, la multiplication du signal d'entrée par un gain désiré peut être réalisée d'une autre façon, par exemple par un miroir de courant programmable ou par d'autres circuits dans lesquels les éléments actifs sont différents des condensateurs 229, 230, 231 et 232.

Il est également clair que dans d'autres modes de réalisation de l'invention, le gain choisi peut être supérieur ou inférieur à 1 et prendre des valeurs autres que des entiers positifs (1, 2, 3 et 4) de la figure 8. Toutefois, l'utilisation d'entiers positifs comme valeurs du gain simplifie le fonctionnement de la division réalisée par le circuit logique 227. De préférence, les valeurs du gain choisi correspondent à des puissances de deux (c'est-à-dire le gain peut prendre des valeurs telles que 4, 2, 1, $^1/_2$, $^1/_4$, ...) de telle sorte que la division du mot numérique produit par le circuit logique 227 implique un simple décalage des bits dans le mot.

L'intégrateur 222 accumule la différence entre le signal d'entrée analogique et le signal de sortie numérique reconverti sous forme analogique. Par exemple, lorsque la plage du signal d'entrée est réglée avec un gain de 1, la tension $V_{in}$ est appliquée seulement sur l'un des condensateurs 229, 230, 231 ou 232. La tension $V_{amp}$ à la sortie de l'amplificateur opérationnel 237 est $V_{amp} = \int_{t1} G* (V_{in}*C_{in} - X*V_{ref}*C_{ref})$, où G est égal à 1, et la différence entre les charges $Q_{in}$ et $\pm Q_{ref}$ est emmagasinée entre les armatures du condensateur 238. Si le gain est changé d'une valeur 1 à une valeur 2 au temps t1, la tension $V_{in}$ est également appliquée aux bornes d'un autre des condensateurs 229, 230, 231 ou 232. A partir de cet instant, la tension $V_{amp}$ devrait être égale à $\int_{t1} 2(Vin*Cin - X*Vref*Cref)$. Toutefois, la charge emmagasinée par le condensateur 238 reste à cet instant toujours égale à $\int_{t1} (V_{in}*C_{in} - X*V_{ref}*C_{ref})$, de sorte qu'il n'y a plus de relation correcte entre la fonction de l'intégrateur et la charge sur son condensateur.

Afin d'adapter la charge dans l'intégrateur 222 à la nouvelle plage et d'éviter ainsi du bruit de commutation, qui résulterait de cette incohérence, le circuit 250 de commande des interrupteurs ferme momentanément les interrupteurs 247 et 248 ce qui charge le condensateur 245 à la même valeur que le condensateur 238. Ensuite, les interrupteurs 247 et 248 sont ouverts, puis les interrupteurs 246 et 249 sont fermés. Ainsi, le condensateur 245 est déchargé et sa charge est transférée sur les armatures du condensateur 238. Si la valeur du condensateur 245 est choisie égale à celle du condensateur 245, la charge emmagasinée par l'intégrateur 222 devient l'équivalent de $\int_{t1} 2(V_{in}*C_{in} - X*V_{ref}*C_{ref})$ et l'erreur accumulée dans cet intégrateur est doublée pour compenser la multiplication par deux du gain choisi.

On va maintenant supposer que le gain doit être réduit au temps t2 d'une valeur 2 à une valeur 1.

Juste avant l'instant t2, deux condensateur parmi les condensateurs 229, 230, 231 ou 232 sont connectés en parallèle et la charge emmagasinée par le condensateur 238 est égale à $\int_{t1} 2(\text{Vin*Cin} \pm \text{X*Vref*Cref})$. Au temps t2, la tension $V_{in}$ n'est appliquée qu'à l'un de ces condensateurs. A cet instant, la tension $V_{amp}$ devrait être égale à $\int_{t1} (\text{Vin*Cin} - \text{X*Vref*Cref})$. Toutefois, la charge emmagasinée par le condensateur 238 à cet instant reste toujours égale à $2(V_{in}{}^{*}C_{in} - X^{*}V_{ref}C_{ref})$. Pour compenser cette différence, le circuit 250 de commande des interrupteurs décharge tout d'abord le condensateur 245 en fermant momentanément les interrupteurs 248 et 249. Ensuite, les interrupteurs 246 et 247 sont fermés ce qui relie le condensateur 245 en parallèle avec le condensateur 238. Si on choisit pour le condensateur 245 une valeur égale à celle du condensateur 238, la charge emmagasinée entre les armatures du condensateur 238 est réduite de moitié. Le condensateur 245 est alors déconnecté de l'intégrateur 222. La charge emmagasinée par l'intégrateur 222 devient alors $\int_{t1} (V_{in}{}^{*}C_{in} - X^{*}V_{ref}{}^{*}C_{ref})$ et l'erreur qui y est accumulée est réduite de moitié pour compenser la division par deux du gain choisi.

Le convertisseur sigma-delta de la figure 8 est un exemple particulier de la façon par laquelle le bruit de commutation qui résulte d'un changement de la plage du signal d'entrée, peut être compensé par la multiplication de l'erreur accumulée dans l'intégrateur par un rapport R du gain nouvellement choisi par rapport au gain choisi précédemment. Ce fonctionnement peut être mis en oeuvre plus facilement si la relation R entre les divers gains successifs est constante, car dans ce cas, il suffit de réaliser une multiplication et une division de l'erreur accumulée par la relation R. De plus, comme l'utilisation de gains qui sont des puissances de 2 dans de tels convertisseurs simplifie les opérations arithmétiques exécutées par le circuit logique 227, la valeur de R peut de façon commode être égale à 2. L'utilisation des condensateurs 238 et 245 dans la figure 8 est un exemple pratique d'une telle réalisation.

Le convertisseur sigma-delta décrit en faisant référence à la figure 8 convertit une tension d'entrée analogique en un mot de sortie numérique, mais il est clair que, selon la présente invention, l'utilisation de ce convertisseur n'est pas limitée à cette application. Par exemple, l'invention peut être appliquée dans le cas où on mesure une capacité qui est convertie en un signal de sortie variable. Dans ce cas, les condensateurs 229, 230, 231 et 232 peuvent être remplacés par une source de tension ayant quatre valeurs prédéterminées qui sont appliquées aux bornes de la capacité à mesurer selon un gain choisi du signal d'entrée.

Selon une variante, le signal d'entrée appliqué au convertisseur sigma-delta de la présente invention peut être un courant analogique directement envoyé vers l'intégrateur 222, cas dans lequel l'amplificateur de signal d'entrée comprend un amplificateur de courant réglable ou un réseau de résistances. D'autres variantes et applications possibles sont a la portée de l'homme de l'art.

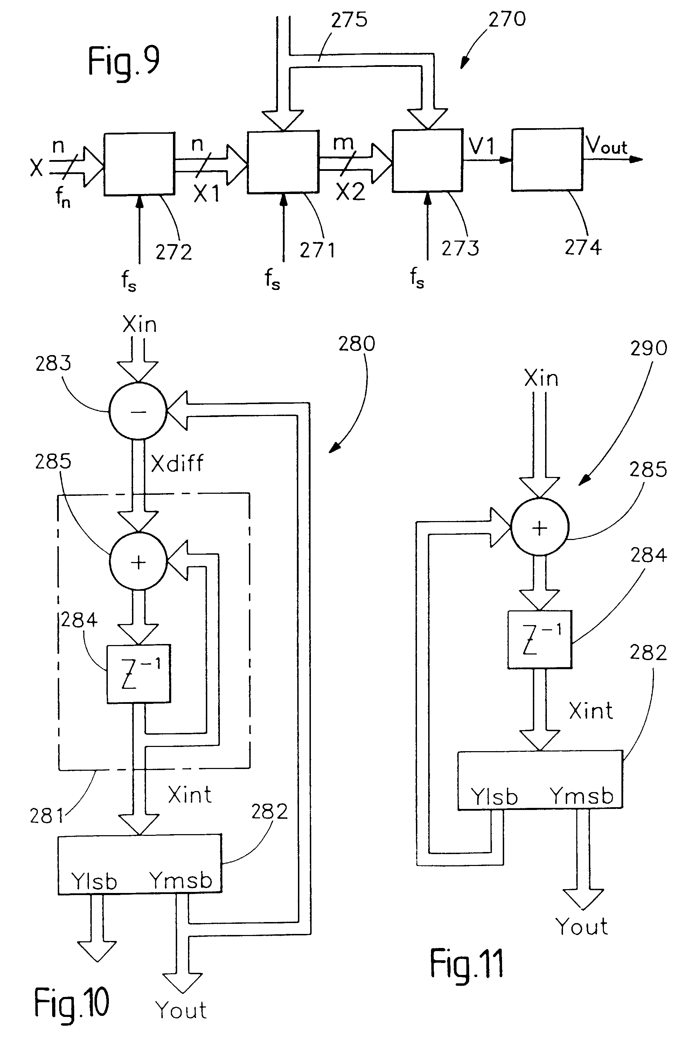

Une autre application de la présente invention est représentée à la figure 9 qui montre un convertisseur 270 numérique/analogique à suréchantillonnage comprenant un convertisseur sigma-delta 271 à plusieurs plages destiné à convertir une grandeur numérique à n bits en une grandeur numérique à m bits. Outre le convertisseur sigma-delta 271, le convertisseur 270 comprend un filtre numérique d'interpolation 272, un convertisseur élémentaire numérique/analogique 273 et un filtre passe-bas analogique 274.

Un signal d'entrée X est constitué par un mot numérique à n bits qui est appliqué au filtre d'interpolation 272. Le signal X est d'abord interpolé et ensuite échantillonné à une fréquence $f_s$ dans le filtre d'interpolation 272, $f_s$ étant nettement plus grande que la fréquence de Nyquist $f_N$ du signal d'entrée X. Dans la suite on expliquera que le convertisseur sigma-delta 271 est utilisé comme conformateur numérique de bruit, fonctionnant à une fréquence d'horloge $f_s$, qui "approxime" le signal X1 du filtre d'interpolation de manière à obtenir un signal X2 qui consiste en un mot numérique à m bits, n > m. Le bruit engendré par l'approximation est ainsi rejeté vers des fréquences supérieures à la fréquence d'échantillonage $f_s$. Le mot "approximé" X2 est converti en un signal analogique V1 par le convertisseur élémentaire numérique/analogique 273 avant de traverser le filtre passe-bas 274 qui élimine le bruit d'appriximation rejeté vers les fréquences plus élevées.

Afin de rendre maximale la résolution sur une plage de signaux d'entrée, le convertisseur numérique/analogique 270 à sur échantillonnage comprend également un bus 275 destiné à appliquer le gain G choisi au convertisseur sigma-delta 271 et au convertisseur élémentaire D/A 273. Dans le convertisseur sigma-delta 271, le signal X1 est multiplié par le gain G de sorte que le signal X2 est mieux adapté à la plage d'entrée du convertisseur élémentaire D/A 273. Une fois que le signal X2 a été converti sous forme analogique, il est divisé par G de sorte que le signal de sortie filtré $V_{out}$ représente le signal d'entrée numérique X.

On va maintenant se référer à la figure 10 pour expliquer le principe de fonctionnement d'un conformateur numérique de bruit. Sur cette figure 10, on a représenté un convertisseur sigma-delta (conformateur numérique de bruit) 280 comprenant un intégrateur 281, un troncateur 282 et un circuit de soustraction 283. L'intégrateur 281 comprend un registre numérique 284 et un circuit d'addition 285. Un signal numérique $X_{in}$ à n bits est appliqué au convertisseur 280. Un signal numérique $Y_{out}$ à m bits que l'on décrira brièvement ci-après, n > m, est soustrait du signal $X_{in}$ et le signal résultant $X_{diff}$ à n bits est appliqué à l'intégrateur 281. Dans celui-ci, l'intégration est réalisée selon un algorithme qui ajoute la sortie du registre 284 engendrée lors d'un cycle d'horloge précédent au signal $X_{diff}$ et mémorise temporairement la somme qui en résulte dans le registre au cours du cycle d'horloge courant. Le signal $X_{in}$ à n bits provenant de l'intégrateur 281 est tronqué pour former un signal de sortie $Y_{out}$ comprenant les m bits les plus significatifs du signal $X_{int}$. Le signal $Y_{out}$ fournit également un signal de réaction qui est soustrait du signal d'entrée $X_{in}$ par le circuit de soustraction 283.

Une comparaison du convertisseur sigma-delta de la figure 1 avec le conformateur numérique de bruit de la figure 10 montre que le signal d'entrée analogique est remplacé par un signal numérique à n bits, que l'intégrateur 202 est remplacé par l'intégrateur 281 purement numérique et que le comparateur 203 est remplacé par le troncateur 282. La sortie du convertisseur D/A 204 est remplacée par le signal $Y_{out}$ qui n'a pas besoin d'un circuit physique pour être engendré en raison de la division du bus $X_{int}$ en deux parties par le troncateur 282. Enfin, le circuit 206 de combinaison de signaux est remplacé par le circuit de soustraction 283.

On voit donc que le conformateur numérique de bruit 280 de la figure 10 est un équivalent fonctionnel du convertisseur sigma-delta 201 de la figure 1. A cet égard, le conformateur numérique de bruit 280 interpole et suréchantillonne le signal $X_{in}$ à n bits de manière à produire un signal de sortie $Y_{out}$ qui fournit un estimation à m bits du signal d'entrée $X_{in}$. L'erreur de quantification résultant du processus d'échantillonnage est rejetée vers les fréquences plus élevées par l'intégrateur qui est utilisé pour réaliser la conversion sigma-delta.

Sur la figure 10, les m bits $Y_{msb}$ les plus significatifs du signal $X_{int}$ sont soustraits du signal d'entrée $X_{in}$ à n bits par le bloc de soustraction 283, à la suite de quoi l'intégrateur 281 additionne $X_{int}$ au signal résultant. Ceci constitue un équivalent de l'addition directe de (n-m) bits $Y_{lsb}$ les moins significatifs du signal $X_{int}$ au signal $X_{in}$. La figure 11 montre un conformateur numérique de bruit 290 dans lequel cette simplification a été mise en oeuvre. Le conformateur numérique de bruit 290 comprend le registre numérique 284, le troncateur 282 et le circuit d'addition 285 de la figure 10 cependant que dans ce mode de réalisation de l'invention, les bits $Y_{lsb}$ les plus significatifs sont accumulés jusqu'à ce qu'ils produisent un dépassement du signal $Y_{msb}$ et soient ainsi transférés vers la sortie de l'écrêteur $Y_{out}$.

Comme le convertisseur sigma-delta 220 de la figure 8, le convertisseur 290 mémorise ainsi l'erreur de conversion entre son signal d'entrée et son signal de sortie. Dans une application qui nécessite plusieurs plages de signaux d'entrée, une variation du gain du signal d'entrée altère la relation entre la fonction de l'intégrateur et la valeur numérique stockée dans l'accumulateur, ce qui peut être évité en multipliant l'erreur de conversion par le rapport du gain nouveau au gain ancien.

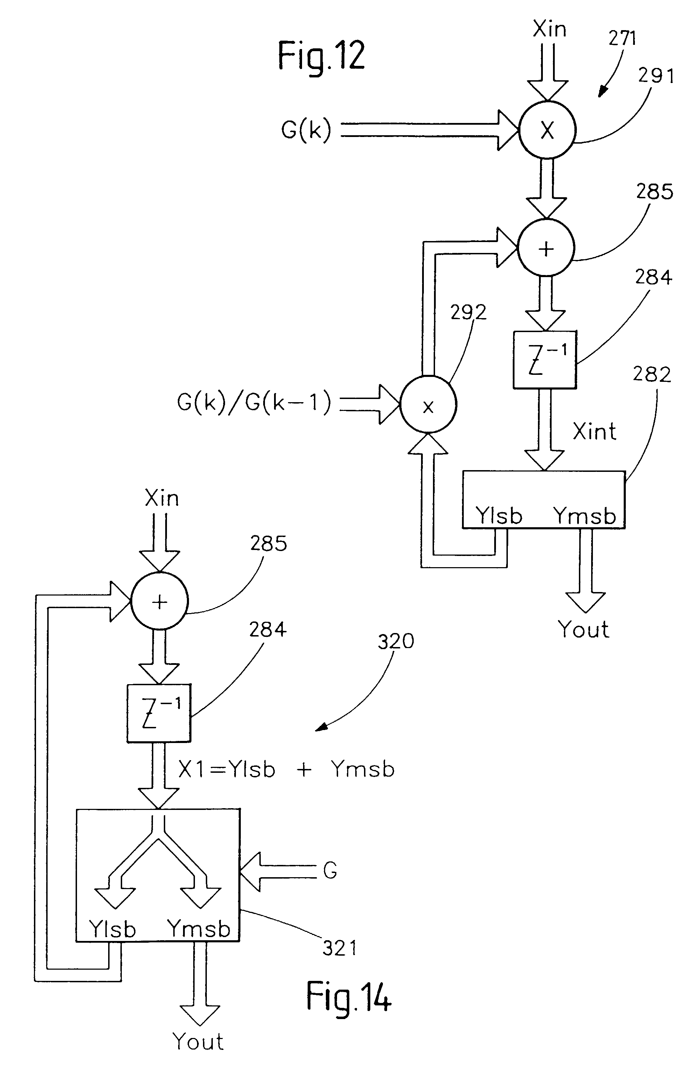

La figure 12 montre un mode de réalisation du convertisseur sigma-delta 271 à plages multiples de la figure 9. Ce dernier comprend le convertisseur 290 de la figure 11 et deux circuits de multiplication 291 et 292. Le circuit de multiplication 291 multiplie le signal d'entrée $X_{in}$ par le signal de gain G(k) choisi provenant du bus 275. La valeur du gain G(k) peut être changée en fonction du choix de la plage du signal d'entrée du convertisseur 271. Comme l'erreur entre le signal d'entrée $X_{in}$ et le signal de sortie $Y_{out}$ est accumulée dans l'accumulateur numérique 284 avec un gain qui dépend de la plage choisie, le changement de la plage du signal d'entrée introduit du bruit de commutation dans l'erreur de conversion mémorisée. Pour éviter ce bruit de commutation, le circuit de multiplication 292 est connecté dans le circuit de contre-réaction entre le troncateur 282 et le circuit d'addition 285, afin de multiplier le signal $Y_{lsb}$ par le rapport du nouveau gain G(k) à l'ancien gain G(k-1).

Bien que ceci ne soit pas essentiel pour l'invention, l'accomplissement de cette multiplication est simplifié si les valeurs du gain sont limitées à des puissances de 2. Dans ce cas, la position des bits dans chacun des mots numériques $X_{in}$ et $Y_{lsb}$ peut être décalée d'un nombre approprié d'emplacements. Ceci peut être réalisé, de préférence, en utilisant des registres à décalage, les signaux de gain G(k) et G(k)/G(k-1) déterminant le nombre de positions dont les bits doivent être décalés.

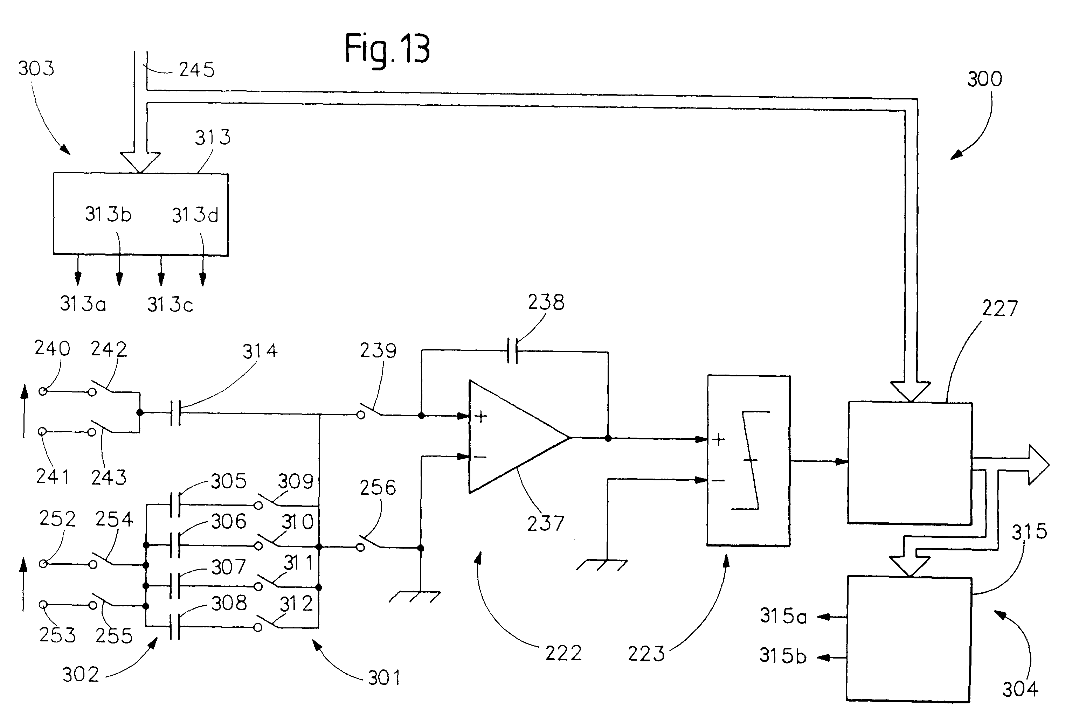

Un autre mode de réalisation de la présente invention sera maintenant décrit en faisant référence à la figure 13 qui montre d'une façon générale, un convertisseur sigma-delta A/D 100 comprenant l'intégrateur 222, le comparateur 223 et un amplificateur 227 du signal de sortie du convertisseur sigma-delta 220. Le fonctionnement de ces composants a déjà été décrit à propos de la figure 8. En outre, le convertisseur sigma-delta 300 comprend un circuit 301 de combinaison de signaux, un amplificateur 302 du signal de réaction, un circuit de réglage de plages 303 et un circuit de contre-réaction 304.

L'amplificateur de contre-réaction 302 comprend quatre condensateurs 305, 306, 307 et 308. Les armatures de ces condensateurs sont respectivement reliées aux bornes d'interrupteurs 309, 310, 311 et 312. Les autres bornes de ces interrupteurs sont reliées ensemble à l'entrée non-inverseuse d'un amplificateur opérationnel 237 par l'intermédiaire de l'interrupteur 256. La tension $V_{ref}$ présente aux bornes 252 et 253 est appliquée sur un ou plusieurs des condensateurs 305, 306, 307 et 308. De préférence, ces condensateurs ont la même valeur $C_{ref}$.

Le circuit de réglage de plages 303 comprend un circuit de commande d'interrupteurs 313 ainsi que des interrupteurs 309, 310, 311 et 312. Le circuit 313 présente quatre sorties 313a, 313b, 313c et 313d pour commander le fonctionnement respectivement des interrupteurs 309, 310, 311 et 312. Le fonctionnement des interrupteurs est commandé sélectivement en fonction du signal de gain provenant du bus 245 de sorte que toute combinaison des condensateurs 305, 306, 307 et 308 peut être connectée de manière à recevoir la tension $V_{ref}$. La charge emmagasinée entre les armatures des condensateurs connectés en parallèle peut ainsi être égale à $C_{ref}*V_{ref}$, $2C_{ref}*V_{ref}$, $3C_{ref}*V_{ref}$ ou $4C_{ref}*V_{ref}$, en fonction du gain qui est présent sur le bus 245.

Le signal d'entrée $V_{in}$ présent entre les bornes 240 et 241 est appliqué aux bornes d'un condensateur 314 dont la valeur est $C_{in}$, au moyen des interrupteurs 242 et 243. Une charge $Q_{in}$ égale à $V_{in}*C_{in}$ est ainsi produite entre les armatures du condensateur $C_{in}$. Cette charge est appliquée à l'entrée inverseuse de l'amplificateur opérationnel 237 par l'intermédiaire de l'interrupteur 239.

Le circuit de contre-réaction 304 comprend un circuit de commande 315, des bornes 252 et 253, les contacteurs 239, 254, 255 et 256 et la source de tension $V_{ref}$. Le circuit de commande 315 détecte le mot numérique à la sortie de l'amplificateur 227 du signal de sortie, ce mot résultant de la multiplication de l'information numérique dans le train de bits provenant du comparateur 223 par l'inverse du gain sur le bus 245. Le circuit de commande 315 présente des sorties 315a et 315b pour permettre la commande du fonctionnement des interrupteurs 254 et 255, respectivement.

La charge $G*Q_{ref}$ est intégrée soit positivement soit négativement en fonction de la valeur +1 ou -1 du bit produit à la sortie du comparateur 223, grâce à la commande du fonctionnement des interrupteurs 254 et 255. La différence entre les charges $Q_{in} \pm G*Q_{ref}$ est emmagasinée entre les armatures du condensateur 238 et elle est ainsi intégrée par l'amplificateur opérationnel 237.

Comme décrit précédemment à propos de la figure 8, le convertisseur sigma-delta 300 est stable tant que la charge $Q_{in}$ est inférieure à la valeur absolue de la charge de réaction $Q_{ref}$. La tension maximale admissible du signal d'entrée $V_{in}$, en tant que valeur absolue, est donnée par $V_{inmax} = V_{ref} * (^{N*Cref}/_{Cin})$, où N est le nombre de condensateurs aux bornes desquels est appliquée la tension de contre-réaction $V_{ref}$. La plage du signal d'entrée pour le signal d'entrée $V_{in}$ peut ainsi être choisie selon le nombre N de condensateurs 305, 306, 307 et 308 connectés en parallèle.

Comme décrit précédemment, le condensateur 238 de l'intégrateur 222 accumule la différence entre le signal d'entrée analogique et le signal de sortie numérique reconverti sous forme analogique. Dans le convertisseur sigma-delta 220 représenté à la figure 8, le bruit de commutation est introduit au moment où la plage du signal d'entrée est modifiée en raison de l'altération de la relation entre le gain du signal d'entrée $V_{in}$ et l'erreur de quantification emmagasinée par le condensateur 238. Ce bruit est évité par la multiplication de l'erreur de quantification par le rapport du nouveau gain à l'ancien gain.

Par contre, dans le mode de réalisation de la figure 13, l'intégrateur 222 accumule l'erreur de quantification indépendamment du gain choisi. Comme la sélection de la plage du signal d'entrée est réalisée par programmation du gain dans le circuit de contre-réaction du convertisseur sigma-delta 300, plutôt que dans le circuit d'entrée, la sortie $V_{amp}$ de l'amplificateur opérationnel 222 est égale à $A(\int_{t1}e(t).dt)$, où A représente le gain fixe du signal d'entrée $V_{in}$. Toute altération de la relation entre le gain du signal d'entrée et l'erreur accumulée dans l'intégrateur du convertisseur sigma-delta et par conséquent tout bruit de commutation qui pourrait en résulter, est ainsi évité.

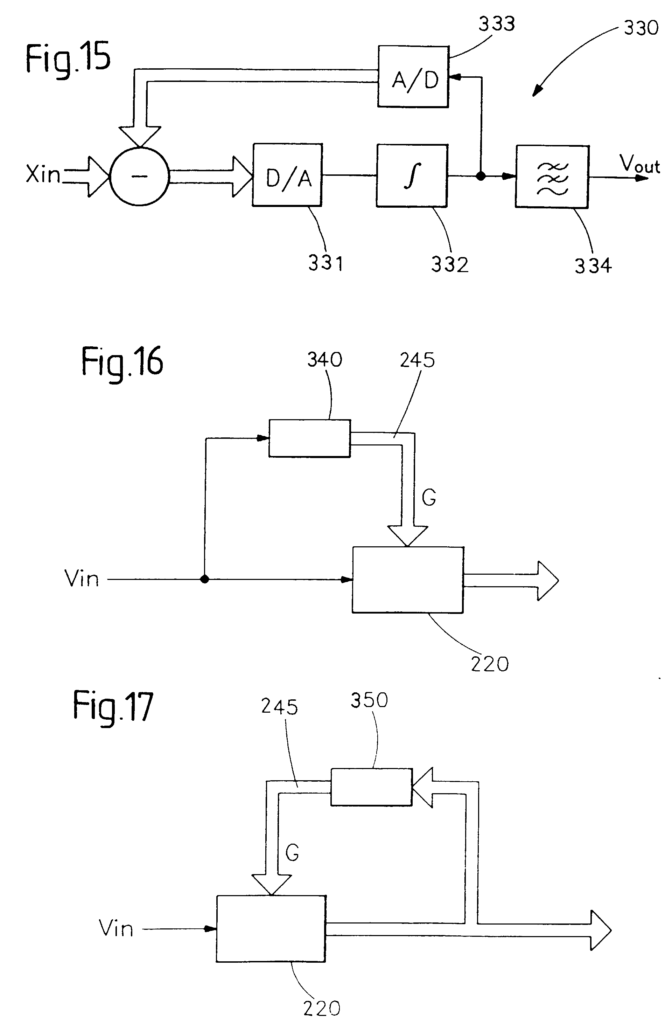

Le convertisseur sigma-delta 300 de la figure 13 peut également être réalisé sous la forme d'un conformateur numérique de bruit destiné à convertir un signal numérique de n bits en un signal numérique de m bits. La figure 14 montre, d'une façon générale, un tel convertisseur sigma-delta 320 comprenant l'accumulateur numérique 284 et le circuit d'addition 285 de la figure 12 et, en outre, un troncateur programmable 321. Le nombre de bits dans le signal $Y_{lsb}$ et par conséquent du signal complémentaire $Y_{msb}$ est modifié par le troncateur 321 en réponse à la valeur du gain sélectionné G qui lui est appliqué; ce qui permet de programmer le circuit de réaction du convertisseur 321. Lorsque le niveau du signal d'entrée est faible, la sensibilité du convertisseur 321 peut être augmentée en réduisant le nombre des bits les moins significatifs accumulés et par conséquent en produisant plus rapidement un dépassement de ces bits dans le bit le plus significatif du signal X1. Comme l'accumulateur accumule toujours la différence entre le signal d'entrée $X_{in}$ et le signal de sortie $Y_{out}$ indépendamment de la plage choisie pour le convertisseur 320, la valeur numérique emmagasinée dans l'accumulateur 284 n'a pas besoin d'être mise à jour, lorsque la plage choisie est modifiée.

On peut voir que le convertisseur sigma-delta de la figure 14 présente l'avantage d'une plus grande simplicité comparé au convertisseur sigma-delta 271 représenté à la figure 12.

Une autre application du convertisseur sigma-delta de la présente invention est montrée à la figure 15 qui représente, d'une façon générale, un convertisseur numérique/analogique 330 à suréchantillonnage monté en boucle fermée. Le convertisseur 330 comporte un circuit direct avec un convertisseur 331 élémentaire D/A et un intégrateur 332, ainsi qu'un circuit de contre-réaction qui comprend un convertisseur analogique/numérique 333. Un filtre basse-bas 334 élimine le bruit à haute fréquence de la tension à la sortie de l'intégrateur 332. Comme dans tous les systèmes asservis, la précision du convertisseur sigma-delta 330 est déterminée essentiellement par le circuit de contre-réaction. Le convertisseur sigma-delta 330 peut être ainsi réalisé grâce à l'utilisation d'un convertisseur A/D 333 précis et d'un convertisseur plus élémentaire D/A 331. Dans les applications à plages multiples, le convertisseur sigma-delta de la présente invention, dans sa forme décrite par exemple à propos des figures 8 et 13, est ainsi approprié de façon idéale pour être utilisé en tant que convertisseur A/D 333. Il est préférable, pour conférer au convertisseur sigma-delta de la présente invention le meilleur rapport signal-bruit, d'optimiser le gain choisi. Si le gain choisi est trop élevé, le convertisseur va saturer lorsque, soit le signal d'entrée, soit le signal de contre-réaction dépasse une certaine amplitude. Il en résulte une "troncation" du signal et une distorsion du signal de sortie. D'autre part, si le gain choisi est trop faible, le fonctionnement du convertisseur conduit à une faible résolution et le rapport signal-bruit est réduit.

La figure 16 représente schématiquement le convertisseur sigma-delta 220 de la figure 8 et un circuit de commande de gain 340, ce dernier pouvant être utilisé également dans les autres modes de réalisation de l'invention. Ce circuit 340 mesure l'amplitude du signal $V_{in}$ mais peut également mesurer son énergie. En fonction de cette amplitude mesurée, le circuit de commande 340 augmente ou diminue la valeur du gain G sur le bus 245 afin que celle-ci puisse être utilisée par le convertisseur sigma-delta 220 pour le réglage de la plage du signal d'entrée. Le circuit de commande 340 ne sera pas décrit en détail, car il peut être réalisé facilement par les spécialistes; il peut comprendre par exemple un circuit mixte analogique/numérique comprenant des détecteurs de seuil, des comparateurs, des "triggers" de Schmitt, des filtres passe-bas et/ou des convertisseurs A/D à faible résolution moyennant quoi ce circuit vérifie le niveau du signal d'entrée et ajuste par conséquent la sensibilité du convertisseur 220 par l'envoi d'un signal représentant la plage choisie au circuit de sélection de plages du convertisseur 220.

La figure 17 montre un autre agencement dans lequel le convertisseur sigma-delta 220 de la figure 8 est commandé par un circuit de commande de gain 350 qui mesure le niveau du signal à la sortie du convertisseur 220. Comme le circuit utilisé est alors pratiquement uniquement numérique, le circuit de commande de gain 220 évite ainsi l'utilisation de circuits analogiques supplémentaires du circuit de commande de gain 340 de la figure 16.

Finalement, l'homme du métier comprendra que le champ d'application de la présente invention ne se limite pas aux circuits comportant un étage d'entrée à gain variable mais qu'il s'étend généralement à tous les dispositifs dans lesquels l'amplitude d'une grandeur captée en entrée peut varier de façon prévisible et dont la variation a un effet comparable à un changement de gain. De façon générale, on pourra également dire que l'invention reste applicable lorsque l'amplitude du signal subit des changements, prévisibles ou détectables, assimilables à un changement de gain par suite d'une perturbation, de changement des caractéristiques des circuits de traitement, etc.

**Revendications**

1. Circuit de traitement (2,120) pour produire un signal de sortie variable en réponse à une grandeur variable captée ou reçue en entrée, ledit circuit de traitement étant associé à un étage ou à un capteur d'entrée (4,110) fournissant un signal avec un facteur d'amplification/atténuation variable et ledit circuit de traitement présentant en outre une caractéristique de réponse qui dépend de variables d'état, ledit circuit comportant des moyens de suppression des transitoires normalement produites par une modification dudit facteur d'amplification/atténuation, lesdits moyens de suppression des transitoires fonctionnant en modifiant la valeur desdites variables d'état en proportion directe de ladite modification du facteur d'amplification/atténuation caractérisé en ce que ledit circuit est un modulateur passe-bande sigma-delta.

2. Circuit de traitement selon la revendication 1, caractérisé en ce que le modulateur sigma-delta est destiné à convertir un signal d'entrée variable en ledit signal de sortie, et comprend :

   - un circuit de combinaison de signaux (221) destiné à additionner ledit signal de sortie dudit signal d'entrée ou à soustraire ces signaux l'un de l'autre, de manière à produire un signal combiné,

   - un intégrateur (222) destiné à intégrer ledit signal combiné de manière à produire un signal intégré, l'intégrateur comprenant un circuit de mémorisation d'erreur (238) destiné à emmagasiner une quantité représentant la valeur temporelle dudit signal combiné,

   - un comparateur (223) destiné à comparer le signal intégré à au moins un niveau prédéterminé de manière à produire ledit signal de sortie,

   - un circuit de contre-réaction (224) destiné à appliquer un signal de réaction représentant ledit signal de sortie audit circuit de combinaison de signaux,

   - un circuit de réglage de plages (226) destiné à modifier ledit facteur d'amplification/atténuation d'une première valeur et à au moins une seconde valeur,

   - un circuit (227) destiné à amplifier ledit signal de sortie par l'inverse dudit facteur d'amplification/atténuation, et

   - un circuit de compensation de bruit (228) destiné à multiplier ladite quantité emmagasinée par le rapport de ladite seconde valeur à ladite première valeur, lorsque ledit facteur d'amplification/atténuation est modifié de ladite première valeur à ladite seconde valeur.

3. Circuit de traitement selon la revendication 1, caractérisé en ce que lesdits moyens de suppression des transitoires comprennent un élément de circuit à capacités commutées commandé par un séquenceur.

4. Circuit de traitement selon la revendication 1, caractérisé en ce que lesdits moyens de suppression des transitoires comprennent un multiplieur prévu pour multiplier un courant par l'intensité d'un signal correspondant au facteur par lequel on modifie le gain dudit étage d'entrée.

5. Circuit de traitement selon la revendication 1, caractérisé en ce que les moyens de suppression des transitoires sont prévus pour modifier les valeurs des variables d'état dans des rapports prédéterminés.

6. Circuit de traitement selon la revendication 1, caractérisé en ce que les moyens de suppression des transitoires sont prévus pour changer les variables d'état d'un facteur quelconque.

7. Circuit de traitement selon la revendication 2, caractérisé en ce que ledit intégrateur (222) comprend un amplificateur (237) présentant une entrée inverseuse, un entrée non-inverseuse et une sortie, ledit circuit d'emmagasinage d'erreur (238) comprenant un condensateur d'emmagasinage connecté entre ladite entrée inverseuse et ladite sortie d'amplificateur, ledit condensateur d'emmagasinage (238) emmagasinant une charge proportionnelle à la valeur temporelle dudit signal combiné.

8. Circuit de traitement selon la revendication 7, caractérisé en ce que ledit circuit de compensation de bruit (228) comprend un circuit pour multiplier par ledit rapport, la valeur dudit condensateur d'emmagasinage, et par conséquent ladite quantité de charge emmagasinée.

9. Circuit de traitement selon la revendication 8, caractérisé en ce que ledit circuit de compensation de bruit (228) comprend au moins un condensateur supplémentaire (245) qui peut être connecté soit en série avec le condensateur d'emmagasinage (238) soit en parallèle avec celui-ci.

10. Circuit de traitement selon la revendication 9, caractérisé en ce que ledit condensateur d'emmagasinage (238) et ledit condensateur supplémentaire (245) ont la même valeur.

11. Circuit de traitement selon l'une quelconque des revendications 2 à 9, caractérisé en ce que ledit signal d'entrée comprend une tension analogique, ledit circuit d'amplification (225) du signal d'entrée comprend un condensateur d'entrée (229, 230, 231, 232) connecté à l'intégrateur (222) pour convertir ladite tension analogique en une charge qui représente le signal d'entrée amplifié, ledit circuit de réglage de plages (226) comprenant des moyens (233, 234, 235, 236) pour modifier la valeur dudit condensateur d'entrée.

12. Circuit de traitement selon la revendication 11, caractérisé en ce que ledit circuit d'amplification (225) du signal d'entrée comprend plusieurs éléments capacitifs (229, 230, 231, 232) ledit circuit de réglage de plages (226) comprenant des interrupteurs (229, 230, 231, 232) pour permettre de mettre en circuit, le cas échéant en parallèle, toute combinaison desdits éléments capacitifs.

13. Circuit de traitement selon la revendication 12, caractérisé en ce que lesdits éléments capacitifs (229, 230, 231, 232) ont la même valeur.

14. Circuit de traitement selon l'une quelconque des revendications 2 à 13, caractérisé en ce que ledit signal d'entrée comprend un condensateur à capacité mesurable qui peut être connecté audit intégrateur (222), ledit circuit d'amplification du signal d'entrée recevant une tension d'entrée prédéterminée qui est appliquée audit condensateur à capacité mesurable pour convertir celui-ci en une charge qui représente cette capacité mesurable, ledit circuit de réglage de plages (226) comprenant des moyens pour modifier la valeur de ladite tension d'entrée.

15. Circuit de traitement selon l'une quelconque des revendications 2 à 14, caractérisé en ce que ledit signal d'entrée est un courant analogique qui est envoyé à l'intégrateur (222), ledit circuit d'amplification (225) du signal d'entrée comprenant un amplificateur du courant analogique, ledit circuit de réglage de plages (226) comprenant des moyens pour modifier l'amplification dudit amplificateur.

16. Circuit de traitement selon la revendication 2, caractérisé en ce que ledit signal d'entrée est une quantité numérique variable, ledit intégrateur (281) comprenant

- un accumulateur numérique (284) pour emmagasiner une valeur numérique à n bits représentant ladite valeur temporelle du signal calculé, ledit accumulateur numérique (284) présentant une entrée et une sortie, et

- un circuit (285) pour additionner la valeur numérique provenant de la sortie dudit accumulateur (284) et ledit signal calculé.

17. Circuit de traitement selon la revendication 16, caractérisé en ce que ledit circuit de compensation de bruit comprend

- un circuit (292) pour modifier ladite valeur numérique emmagasinée dans ledit accumulateur.

18. Circuit de traitement selon la revendication 17, caractérisé en ce que ledit comparateur comprend un troncateur (282) destiné à répartir ladite valeur numérique en ses m bits les plus significatifs ($Y_{msb}$) et ses (n-m) bits les moins significatifs ($Y_{1sb}$), ledit signal de sortie ($Y_{out}$) comprenant lesdits m bits les plus significatifs.

19. Circuit de traitement selon la revendication 18, caractérisé en ce que lesdits (n-m) bits les moins significatifs sont ajoutés audit signal combiné de manière à fournir ledit signal d'entrée de l'accumulateur, ladite sortie d'accumulateur étant appliquée directement audit troncateur, ledit circuit de compensation de bruit multipliant par ledit rapport lesdits (n-m) bits les moins significatifs.

20. Circuit de traitement selon la revendication 19, caractérisé en ce que ledit rapport est égal à une puissance de 2, et ledit circuit de compensation de bruit comprend des moyens pour décaler les (n-m) bits les moins significatifs vers des positions plus significatives dans ladite valeur numérique.

21. Circuit de traitement selon la revendication 1, caractérisé en ce que le modulateur convertisseur sigma-delta est destiné à convertir un signal d'entrée variable en signal de sortie variable et comprend

- un circuit de combinaison de signaux (301) destiné à additionner un signal de contre-réaction représentant ledit signal de sortie et ledit signal d'entrée ou de soustraire ce signal de contre-réaction de ce dernier de manière à produire un signal combiné,
- un intégrateur (222) destiné à intégrer ledit signal combiné de manière à produire un signal intégré, ledit intégrateur comprenant un circuit d'emmagasinage d'erreur (238) qui emmagasine une quantité représentant la valeur temporelle dudit signal combiné,
- un comparateur (222) destiné à comparer ledit signal intégré à au moins un niveau prédéterminé de manière à produire ledit signal de sortie,
- un circuit (302) pour amplifier ledit signal de sortie par ledit facteur d'amplification/atténuation de manière à fournir ledit signal de contre-réaction, et
- un circuit de réglage de plages (303) destiné à modifier ledit facteur d'amplification/atténuation d'une première valeur à une seconde valeur.

22. Circuit de traitement selon la revendication 21, caractérisé en ce que ledit circuit d'amplification (302) du signal de sortie comprend un condensateur de contre-réaction (305, 306, 307, 308) connecté à l'intégrateur pour convertir ledit signal de sortie en une charge qui le représente, ledit circuit de réglage de plages comprenant des moyens (309, 310, 311, 312) pour modifier la valeur dudit condensateur de contre-réaction.

23. Circuit de traitement selon la revendication 22, caractérisé en ce que ledit circuit d'amplification (302) du signal de sortie comprend plusieurs éléments capacitifs (305, 306, 307, 308) ledit circuit de réglage de plages (303) comprenant des moyens d'interruption (309, 310, 311, 312) pour permettre la mise en circuit, le cas échéant en parallèle, desdits éléments capacitifs.

24. Circuit de traitement selon la revendication 23, caractérisé en ce que lesdits éléments capacitifs (305, 306, 307, .308) ont la même valeur.

25. Convertisseur sigma-delta selon la revendication 21, caractérisé en ce que ledit signal d'entrée est une quantité numérique variable, ledit intégrateur (281) comprenant un accumulateur numérique (284) destiné à emmagasiner une valeur numérique à n bits représentant ladite valeur temporelle dudit signal combiné, ledit accumulateur numérique (284) comprenant une entrée et une sortie, ledit comparateur comprenant un troncateur (321) destiné à répartir ladite valeur numérique en ses m bits les plus significatifs et ses (n-m) bits les moins significatifs.

26. Circuit de traitement selon la revendication 25, caractérisé en ce que un nombre desdits (n-m) bits les moins significatifs sont additionnés audit signal combiné de manière à fournir ledit signal d'entrée de l'accumulateur, la sortie de l'accumulateur étant appliquée directement audit troncateur (321), ledit circuit de sélection de plages modifiant le nombre de bits qui sont ajoutés au signal de différence.

27. Circuit de traitement selon l'un quelconque des revendication 2 à 26, caractérisé en ce qu'il comprend également un premier circuit de commande de gain (340) pour mesurer ledit signal d'entrée et pour produire un signal de gain (G) représentant le facteur d'amplification/atténuation destiné à être utilisé par le circuit de réglage de plages (226).

28. Circuit de traitement selon l'une quelconque des revendications 2 à 27, caractérisé en ce qu'il comprend également un second circuit de commande de gain (350) destiné à mesurer ledit signal de sortie et à produire un signal de gain (G) représentant le facteur d'amplification/atténuation destiné à être utilisé par ledit circuit de réglage de plages (226).

29. Convertisseur (270) numérique/analogique à suréchantillonnage comprenant un circuit de traitement selon l'une quelconque des revendications 2 à 28, caractérisé en ce qu'il comprend également

- un filtre d'interpolation (272) destiné à échantillonner un signal d'entrée numérique de manière à fournir un signal échantillonné à n bits,
- un convertisseur élémentaire (273) numérique/analogique destiné à fournir un signal analogique qui représente ledit signal d'entrée numérique, ledit convertisseur sigma-delta (271) étant destiné à recevoir lesdits n bits du signal échantillonné et à appliquer un signal conformateur de bruit à m bits représentant ledit signal échantillonné au convertisseur (273) élémentaire numérique/analogique.

30. Convertisseur (330) numérique/analogique à suréchantillonnage comprenant un circuit de traitement selon l'une quelconque des revendications 2 à 29, caractérisé en ce qu'il comprend également

- un circuit d'entrée comprenant un convertisseur numérique/analogique (331) destiné à convertir un signal numérique de différence en un signal de différence analogique et un intégrateur (332) destiné à intégrer ledit signal de différence analogique de manière à produire un signal de sortie analogique,
- un circuit de contre-réaction comprenant un convertisseur (333) analogique/numérique sigma-delta destiné à convertir ledit signal de sortie analogique en un signal numérique de contre-réaction, et un circuit de combinaison de signaux destiné à combiner un signal d'entrée analogique avec ledit signal de contre-réaction de manière à produire ledit signal combiné.

**Claims**

1. Processing circuit (2, 120) for producing a variable output signal in response to a variable quantity picked up or received as input, said processing circuit being associated with a stage or with an input sensor (4, 100) furnishing a signal with a variable amplification/attenuation factor and said processing circuit further exhibiting a response characteristic which depends from state variables, said circuit including means for suppressing transients normally produced a by modification of said amplification/attenuation factor, said means for suppressing transients functioning by modifying the value of said state variables in direct proportion to said modification of the amplification/ attenuation factor, characterized in that said circuit is a sigma-delta band pass modulator.

2. Processing circuit according to claim 1, characterized in that the sigma-delta modulator is intended to convert a variable input signal into said variable output signal, and comprises :

- a signal combining circuit (221) for adding or subtracting said output signal from said input signal so as to produce a combined signal,
- an integrator (222) for integrating said combined signal so as to produce an integrated signal, the integrator having an error storage circuit (238) for storing a quantity representative of the temporal value of said combined signal,
- a comparator (223) for comparing the integrated signal to at least one pre-defined level so as to produce said output signal,
- a feedback circuit (224) for supplying a feedback signal representative of said output signal to said combining circuit,
- a range setting circuit (226) for altering said amplification/attenuation factor between a first value and at least a second value,
- a circuit (227) for amplifying said output signal by the inverse of said amplification/attenuation factor, and
- a noise compensation circuit (228) for multiplying said stored quantity by the ratio of said second value to said first value, when said amplification/attenuation factor is changed from said first value to said second value.

3. Processing circuit according to claim 1, characterized in that said means for suppressing transients comprise a switched capacitor circuit element controlled by a sequencer.

4. Processing circuit according to claim 1, characterized in that said means for suppressing transients comprise a multiplier provided for multiplying a current by the intensity of a signal corresponding to the factor by which the gain of said input stage is modified.

5. Processing circuit according to claim 1, characterized in that the means for suppressing transients are provided to modify the values of the state variables in predetermined relationships.

6. Processing circuit according to claim 1, characterized in that the means for suppressing transients are provided to change the state variables by an arbitrary factor.

7. Processing circuit according to claim 2, characterized in that said integrator (222) comprises an amplifier (237) having an inverting input, a non-inverting input and an output, said error storage circuit (238) comprising a storage capacitance connected between said inverting input and said amplifier output, said storage capacitance (238) storing a charge proportional to said temporal value of said difference signal.

8. Processing circuit according to claim 7, characterized in that said noise compensation circuit (228) comprises a circuit for multiplying the value of said storage capacitance, and thus said quantity of stored charge, by said ratio.

9. Processing circuit according to claim 8, characterized in that said noise compensation circuit (228) comprises at least one additional capacitance (245) connectable either in series with said storage capacitance (238), or in parallel with said storage capacitance (238).

10. Processing circuit according to claim 9, characterized in that said storage capacitance (238) and said additional capacitance (245) have the same value.

11. Processing circuit according to any one of the claims 2 to 9, characterized in that said input signal comprises an analog voltage, said input signal amplifying circuit (225) comprises an input capacitance (229, 230, 231, 232), connected to said integrator (222) for converting said analog voltage into a charge representative of said amplified input signal, said range setting circuit (226) comprising means (233, 234, 235, 236) for altering the value of said input capacitance.

12. Processing circuit according to claim 11, characterized in that said input signal amplifying circuit (225) comprises a plurality of capacitive elements (229, 230, 231, 232), said range setting circuit (226) comprising switching means (229, 230, 231, 232) for connecting one or more of said capactive elements in parallel.

13. Processing circuit according to claim 12, characterized in that said capacitive elements (229, 230, 231, 232) have the same value.

14. Processing circuit according to any one of the claims 2 to 13, characterized in that said input signal comprises a measurable capacitance connectable to said integrator (222), said input signal amplifying circuit receiving an preselected input voltage applied across said measurable capacitance for converting said measurable capacitance into a charge representative thereof, said range setting circuit (226) comprising means for altering the value of said input voltage.

15. Processing circuit according to any one of the claims 2 to 14, characterized in that said input signal comprises an analog current supplied to said integrator (222), said input signal amplifying circuit (225) comprising an amplifier for amplifying said analog current, said range setting circuit (226) comprising means for altering the amplification of said amplifier means.

16. Processing circuit according to claim 2, characterized in that said input signal is a variable digital quantity, said integrator (281) comprising

- a digital accumulator (284) for storing a digital value of n bits representative of said temporal value of said combined signal, said digital accumulator (284) having an input and an output, and
- a circuit (285) for adding the digital value from said accumulator (284) output to said combined signal.

17. Processing circuit according to claim 16, characterized in that said noise compensation circuit comprises

- a circuit (292) for altering said digital value stored in said accumulator.

18. Processing circuit according to claim 17, characterized in that said comparator comprises a truncator (282) for separating said digital value into its m most-significant-bits ($Y_{msb}$) and its (n-m) least-significant-bits ($Y_{lsb}$), said output signal ($Y_{out}$) comprising said m most significant bits.

19. Processing circuit according to claim 18, characterized in that said (n-m) least-significant-bits are added to said combined signal so as to provide said accumlator input signal, said accumulator output being supplied directly to said truncator, said noise compensating circuit multiplying said (n-m) least-significant-bits by said ratio.

20. Processing circuit according to claim 19, characterized in that said ratio equals a power of 2, and said noise compensating circuit comprises means for shifting said (n-m) least-significant-bits to more significant positions in said digital value.

21. Processing circuit according to claim 1, characterized in that the sigma-delta modulator is intended to convert a variable input signal into a variable output signal and comprises

- a signal combining circuit (301) for adding or subtracting a feedback signal representative of said output signal from said input signal so as to produce a combined signal,
- an integrator (222) for integrating said combined signal so as to produce an integrated signal, said integrator having an error storage circuit (238) for storing a quantitiy representative of the temporal value of said combined signal,

- a comparator (222) for comparing said integrated signal to at least one pre-defined level so as to produce said output signal,
- a circuit (302) for amplifying said output signal by said amplification/attenuation factor so as to provide said feedback signal, and
- a range setting circuit (303) for altering said amplification/attenuation factor between a first value and at least a second value.

22. Processing circuit according to claim 21, characterized in that said output signal amplifying circuit (302) comprises a feedback capacitance (305, 306, 307, 308), connected to said integrator for converting said output signal into a charge representative thereof, said range setting circuit comprising means (309, 310, 311, 312) to alter the value of said feedback capacitance.

23. Processing circuit according to claim 22, characterized in that said output signal amplifying circuit (302) comprises a plurality of capacitive elements (305, 306, 307, 308), said range setting circuit (303) comprising switching means (309, 310, 311, 312) for connecting one or more of said capacitive elements in parallel.

24. Processing circuit according to claim 23, characterized in that said capacitive elements (305, 306, 307, 308) have the same value.

25. Processing circuit according to claim 21, characterized in that said input signal is a variable digital quantity, said integrator (281) comprising a digital accumulator (284) for storing a digital value of n bits representative of said temporal value of said combined signal, said digital accumulator (284) having an input and an output, said comparator comprising a truncator (321) for separating said digital value into its m most-significant-bits and its (n-m) least-significant-bits.

26. Processing circuit according to claim 25, characterized in that a number of said (n-m) least-significant-bits are added to said difference signal so as to provide said accumulator input signal, said accumulator output being supplied directly to said truncator (321), said range selection circuit altering the number of said bits added to said difference signal.

27. Processing circuit according to any one of the claims 2 to 26, characterized in that it further comprises a first gain control circuit (340) for measuring said input signal and producing a gain signal (G) representative of said amplification/attenuation factor for use by said range setting circuit (226).

28. Processing circuit according to any one of the claims 2 to 27, characterized in that it further comprises a second gain control circuit (350) for measuring said output signal and producing a gain signal (G) representative of said amplification/attenuation factor for use by said range setting circuit (226).

29. Oversampling digital/analog converter (270) including a processing circuit according to any one of the claims 2 to 28, characterized in that it further comprises

- an interpolating filter (272) for sampling a digital input signal so as to supply a sampled signal of n bits,
- an elementary digital/analog converter (273) for supplying an analog signal representative of said digital input signal, said sigma-delta converter (271) receiving said n bits of sampled signal and supplying a noise-shaped signal of m bits representative of said sampled signal to said elementary digital/analog converter (273).

30. Oversampling digital/analog converter (330) including a processing circuit according to any one of the claims 2 to 29, characterized in that it further comprises

- an input branch having a digital/analog converter (331) for converting a digital difference signal into an analog difference signal and an integrator (332) for integrating said analog difference signal so as to produce an analog output signal,
- a feedback branch having an sigma-delta analog/ digital converter (333) for converting said analog output signal into a digital feedback signal, and
- a signal combining circuit for combining an analog input signal with said feedback signal so as to produce said combined signal.

**Patentansprüche**

1. Verarbeitungsschaltkreis (2, 120), um ein variables Ausgangssignal in Antwort auf eine variable, am Eingang erfaßte oder empfangene Größe zu erzeugen, wobei der Verarbeitungsschaltkreis mit einer Eingangsstufe oder einem Eingangssensor (4, 110), ein Signal mit einem variablen Verstärkungs-/ Dämpfungsfaktor erzeugend, verbunden ist und wobei der Verarbeitungsschaltkreis zudem eine Antwortcharakteristik aufweist, die von Zustandsvariablen abhängt, wobei der Schaltkreis Mittel zur Unterdrückung von üblicherweise bei einer Änderung des Verstärkungs-/Dämpfungsfaktors erzeugten Schwankungen umfaßt, wobei die Mittel zur Unterdrückung der Schwankungen durch zur Änderung des Verstärkungs-/Dämpfungsfaktors direkt proportionale Änderung des Wertes der Zustandsvariablen funktionieren, dadurch gekennzeichnet, daß der Schaltkreis ein Sigma-Delta-Bandpaßmodulator ist.

2. Verarbeitungsschaltkreis nach Anspruch 1, dadurch gekennzeichnet, daß der Sigma-Delta-Modulator dazu bestimmt ist, ein variables Eingangssignal in das Ausgangssignal umzuwandeln, und umfaßt:

   - einen Schaltkreis zur Kombination von Signalen (221), dazu bestimmt, das Ausgangssignal zu dem Eingangssignal zu addieren oder eines dieser Signale vom anderen zu subtrahieren, so daß ein kombiniertes Signal erzeugt wird,
   - einen Integrator (222), dazu bestimmt, das kombinierte Signal zu integrieren, so daß ein integriertes Signal erzeugt wird, wobei der Integrator einen Schaltkreis zur Speicherung von Fehlern (238), dazu bestimmt, eine den Zeitwert des kombinierten Signals repräsentierende Größe zu speichern, umfaßt,
   - einen Komparator (223), dazu bestimmt, das integrierte Signal mit mindestens einem vordefinierten Pegel so zu vergleichen, daß das Ausgangssignal erzeugt wird,
   - einen Rückkopplungsschaltkreis (224), dazu bestimmt, ein das Ausgangssignal repräsentierendes Rückkopplungssignal an den Schaltkreis zur Kombination von Signalen anzulegen,
   - einen Bereichsregelschaltkreis (226), dazu bestimmt, den Verstärkungs-/Dämpfungsfaktor um einen ersten Wert und auf mindestens einen zweiten Wert zu ändern,
   - einen Schaltkreis (227), dazu bestimmt, das Ausgangssignal um den Kehrwert des Verstärkungs-/Dämpfungsfaktors zu verstärken, und
   - einen Rauschkompensationsschaltkreis (228), dazu bestimmt, die gespeicherte Größe mit dem Verhältnis des zweiten Wertes zu dem ersten Wert zu multiplizieren, wenn der Verstärkungs-/Dämpfungsfaktor von einem ersten Wert auf den zweiten Wert verändert wird.

3. Verarbeitungsschaltkreis nach Anspruch 1, dadurch gekennzeichnet, daß die Mittel zur Unterdrückung der Schwankungen ein Schaltungselement von umschaltbaren, durch einen Reihenschalter gesteuerten Kapazitäten umfassen.

4. Verarbeitungsschaltkreis nach Anspruch 1, dadurch gekennzeichnet, daß die Mittel zur Unterdrückung der Schwankungen einen Multiplikator umfassen, welcher vorgesehen ist, um einen Strom mit der Intensität eines dem Faktor, mit welchem man den Verstärkungsfaktor der Eingangsstufe ändert, entsprechenden Signals zu multiplizieren.

5. Verarbeitungsschaltkreis nach Anspruch 1, dadurch gekennzeichnet, daß die Mittel zur Unterdrückung der Schwankungen vorgesehen sind, um die Zustandsvariablen in vorbestimmten Proportionen zu ändern.

6. Verarbeitungsschaltkreis nach Anspruch 1, dadurch gekennzeichnet, daß die Mittel zur Unterdrückung der Schwankungen vorgesehen sind, um die Zustandsvariablen um irgendeinen Faktor zu ändern.

7. Verarbeitungsschaltkreis nach Anspruch 2, dadurch gekennzeichnet, daß der Integrator (222) einen Verstärker (237) umfaßt, welcher einen invertierenden Eingang, einen nicht-invertierenden Eingang und einen Ausgang aufweist, wobei der Schaltkreis zur Speicherung von Fehlern (238) einen mit dem invertierenden Eingang und dem Ausgang des Verstärkers verbundenen Speicherkondensator umfaßt, wobei der Speicherkondensator (238) eine zu dem Zeitwert des kombinierten Signals proportionale Ladung speichert.

8. Verarbeitungsschaltkreis nach Anspruch 7, dadurch gekennzeichnet, daß der Rauschkompensationsschaltkreis (228) einen Schaltkreis umfaßt, um den Wert des Speicherkondensators und folglich die Größe der akkumulierten Ladung mit dem Verhältnis zu multiplizieren.

9. Verarbeitungsschaltkreis nach Anspruch 8, dadurch gekennzeichnet, daß der Rauschkompensationsschaltkreis (228) mindestens einen zusätzlichen Kondensator (245) umfaßt, welcher entweder mit dem Speicherkondensator (238) in Serie oder mit diesem parallel verbunden sein kann.

10. Verarbeitungsschaltkreis nach Anspruch 9, dadurch gekennzeichnet, daß der Speicherkondensator (238) und der zusätzliche Kondensator (245) den gleichen Wert haben.

11. Verarbeitungsschaltkreis nach einem der Ansprüche 2 bis 9, dadurch gekennzeichnet, daß das Eingangssignal eine analoge Spannung umfaßt, der Schaltkreis (225) zum Verstärken des Eingangssignals einen an den Integrator (222) zum Umwandeln der analogen Spannung in eine das verstärkte Eingangssignal repräsentierende Ladung angeschlossenen Eingangskondensator (229, 230, 231, 232) umfaßt, wobei der Bereichsregelschaltkreis (226) Mittel (233, 234, 235, 236) umfaßt, um den Wert des Eingangskondensators zu ändern.

12. Verarbeitungsschaltkreis nach Anspruch 11, dadurch gekennzeichnet, daß der Schaltkreis zum Verstärken (225) des Eingangssignals mehrere kapazitive Elemente (229, 230, 231, 232) umfaßt, wobei der Bereichsregelschaltkreis (226) Schalter (229, 230, 231, 232) umfaßt, die es ermöglichen, alle Kombinationen der kapazitiven Elemente gegebenenfalls parallel in den Schaltkreis einzufügen.

13. Verarbeitungsschaltkreis nach Anspruch 12, dadurch gekennzeichnet, daß die kapazitiven Elemente (229, 230, 231, 232) den gleichen Wert haben.

14. Verarbeitungsschaltkreis nach einem der Ansprüche 2 bis 13, dadurch gekennzeichnet, daß das Eingangssignal einen Kondensator einer meßbaren Kapazität umfaßt, welcher an den Integrator (222) angeschlossen werden kann, wobei der Schaltkreis zum Verstärken des Eingangssignals eine vorbestimmte Eingangsspannung, welche an den Kondensator mit meßbarer Kapazität angelegt wird, um diese in eine diese meßbare Kapazität repräsentierende Ladung umzuwandeln, empfängt, wobei der Bereichsregelschaltkreis (226) Mittel umfaßt, um den Wert der Eingangsspannung zu ändern.

15. Verarbeitungsschaltkreis nach einem der Ansprüche 2 bis 14, dadurch gekennzeichnet, daß das Eingangssignal ein analoger Strom ist, welcher vom Integrator (222) abgegeben wird, wobei der Schaltkreis zum Verstärken (225) des Eingangssignals einen Analogstromverstärker umfaßt, wobei der Bereichsregelschaltkreis (226) Mittel umfaßt, um die Verstärkung des Verstärkers zu ändern.

16. Verarbeitungsschaltkreis nach Anspruch 2, dadurch gekennzeichnet, daß das Eingangssignal eine variable numerische Größe ist, wobei der Integrator (281) umfaßt

- einen numerischen Akkumulator (284), um einen den Zeitwert des berechneten Signals repräsentierenden numerischen Wert mit n Bits zu speichern, wobei der numerische Akkumulator (84) einen Eingang und einen Ausgang umfaßt, und
- einen Schaltkreis (285), um den vom Ausgang des Akkumulators (284) stammenden numerischen Wert und das berechnete Signal zu addieren.

17. Verarbeitungsschaltkreis nach Anspruch 16, dadurch gekennzeichnet, daß der Rauschkompensationsschaltkreis

- einen Schaltkreis (292), um den im Akkumulator gespeicherten numerischen Wert zu ändern, umfaßt.

18. Verarbeitungsschaltkreis nach Anspruch 17, dadurch gekennzeichnet, daß der Komparator einen Teiler (282) umfaßt, welcher dazu bestimmt ist, den numerischen Wert in seine m höchstwertigen Bits ($Y_{msb}$) und seine (n-m) niedrigstwertigen Bits ($Y_{lsb}$) aufzuteilen, wobei das Ausgangssignal ($Y_{out}$) die m höchstwertigen Bits umfaßt.

19. Verarbeitungsschaltkreis nach Anspruch 18, dadurch gekennzeichnet, daß die (n-m) niedrigstwertigen Bits dem kombinierten Signal so zugefügt werden, daß das Eingangssignal des Akkumulators erzeugt wird, wobei der Ausgang des Akkumulators direkt an den Teiler angelegt ist, wobei der Rauschkompensationsschaltkreis die (n-m) niedrigstwertigen Bits mit dem Verhältnis multipliziert.

20. Verarbeitungsschaltkreis nach Anspruch 19, dadurch gekennzeichnet, daß das Verhältnis eine Potenz von 2 ist, und der Rauschkompensationsschaltkreis Mittel umfaßt, um die (n-m) niedrigstwertigen Bits im numerischen Wert gegen die Positionen der höchstwertigen Bits zu verschieben.

21. Verarbeitungsschaltkreis nach Anspruch 1, dadurch gekennzeichnet, daß der Sigma-Delta-Umwandlungsmodulator dazu bestimmt ist, ein variables Eingangssignal in ein variables Ausgangssignal umzuwandeln, und umfaßt

- einen Schaltkreis zum Kombinieren von Signalen (301), dazu bestimmt, ein das Ausgangssignal repräsentierendes Rückkopplungssignal und das Eingangssignal zu addieren oder dieses Rückkopplungssignal von letzterem zu subtrahieren, so daß ein kombiniertes Signal erzeugt wird,
- einen Integrator (222), dazu bestimmt, das kombinierte Signal so zu integrieren, daß ein integriertes Signal erzeugt wird, wobei der Integrator einen Schaltkreis zum Speichern von Fehlern (238) umfaßt, welcher eine den Zeitwert des kombinierten Signals repräsentierende Größe speichert,
- einen Komparator (222), dazu bestimmt, das integrierte Signal mit mindestens einem vorbestimmten Pegel so zu vergleichen, daß das Ausgangssignal erzeugt wird,
- einen Schaltkreis (302), um das Ausgangssignal mit dem Verstärkungs-/Dämpfungsfaktor so zu verstärken, daß das Rückkopplungssignal erzeugt wird, und
- einen Bereichsregelschaltkreis (303), dazu bestimmt, den Verstärkungs-/Dämpfungsfaktor von einem ersten Wert auf einen zweiten Wert zu ändern.

22. Verarbeitungsschaltkreis nach Anspruch 21, dadurch gekennzeichnet, daß der Schaltkreis zum Verstärken (302) des Ausgangssignals einen Rückkopplungskondensator (305, 306, 307, 308) umfaßt, welcher an den Integrator angeschlossen ist, um das Ausgangssignal in eine dementsprechende Ladung umzuwandeln, wobei der Bereichsregelschaltkreis Mittel (309, 310, 311, 312) umfaßt, um den Wert des Rückkopplungskondensators zu ändern.

23. Verarbeitungsschaltkreis nach Anspruch 22, dadurch gekennzeichnet, daß der Schaltkreis (302) zum Verstärken des Ausgangssignals mehrere kapazitive Elemente (305, 306, 307, 308) umfaßt, wobei der Bereichsregelschaltkreis (303) Mittel zur Unterbrechung (309, 310, 311, 312) umfaßt, um es zu ermöglichen, die kapazitiven Elemente gegebenenfalls parallel in den Schaltkreis einzufügen.

24. Verarbeitungsschaltkreis nach Anspruch 23, dadurch gekennzeichnet, daß die kapazitiven Elemente (305, 306, 307, 308) den gleichen Wert haben.

25. Sigma-Delta-Umwandler nach Anspruch 21, dadurch gekennzeichnet, daß das Eingangssignal eine variable numerische Größe ist, wobei der Integrator (281) einen numerischen Akkumulator (284) umfaßt, dazu bestimmt, einen den Zeitwert des kombinierten Signals repräsentierenden numerischen Wert mit n Bits zu speichern, wobei der numerische Akkumulator (284) einen Eingang und einen Ausgang umfaßt, wobei der Komparator einen Teiler (321) umfaßt, dazu bestimmt, den numerischen Wert in seine m höchstwertigen Bits und seine (n-m) niedrigstwertigen Bits aufzuteilen.

26. Verarbeitungsschaltkreis nach Anspruch 25, dadurch gekennzeichnet, daß eine Anzahl der (n-m) niedrigstwertigen Bits zu dem kombinierten Signal addiert werden, so daß das Eingangssignal des Akkumulators erzeugt wird, wobei der Ausgang des Akkumulators direkt am Teiler (321) anliegt und der Schaltkreis zur Bereichsauswahl die Anzahl der Bits, welche zu dem Differenzsignal hinzugefügt werden, ändert.

27. Verarbeitungsschaltkreis nach einem der Ansprüche 2 bis 26, dadurch gekennzeichnet, daß er zudem einen ersten Schaltkreis zur Verstärkungskontrolle (340) umfaßt, um das Eingangssignal zu messen und um ein dem Verstärkungs-/Dämpfungsfaktor entsprechendes Verstärkungssignal (G) zu erzeugen, der dazu bestimmt ist, durch den Bereichsregelschaltkreis (226) benutzt zu werden.

28. Verarbeitungsschaltkreis nach einem der Ansprüche 2 bis 27, dadurch gekennzeichnet, daß er zudem einen zweiten Schaltkreis zur Verstärkungskontrolle (350) umfaßt, um das Ausgangssignal zu messen und um ein dem Verstärkungs-/Dämpfungsfaktor entsprechendes Verstärkungssignal (G) zu erzeugen, das dazu bestimmt ist, durch den Bereichsregelschaltkreis (226) benutzt zu werden.

29. Übersampelnder Digital/Analog-Wandler (270), umfassend einen Verarbeitungsschaltkreis nach einem der Ansprüche 2 bis 28, dadurch gekennzeichnet, daß er zudem umfaßt

    - ein Interpolationsfilter (272), dazu bestimmt, Momentwerte eines numerisches Eingangssignals so zu erfassen, daß ein Momentwertsignal mit n Bits erzeugt wird,
    - einen einfachen Digital/Analog-Wandler (273), dazu bestimmt, ein analoges Signal zu erzeugen, welches das numerische Eingangssignal repräsentiert, wobei der Sigma-Delta-Konverter (271) dazu bestimmt ist, die n Bits des Momentwertsignals zu empfangen und ein das Momentwertsignal repräsentierendes Signal mit m Bits und entsprechendem Rauschen an den einfachen Digital/Analog-Wandler anzulegen.

30. Übersampelnder Digital/Analog-Wandler (330), umfassend einen Verarbeitungsschaltkreis nach einem der Ansprüche 2 bis 29, dadurch gekennzeichnet, daß er zudem umfaßt

    - einen Eingangsschaltkreis, umfassend einen Digital/Analog-Wandler (331), dazu bestimmt, ein numerisches Differenzsignal in ein analoges Differenzsignal umzuwandeln, und einen Integrator (332), dazu bestimmt, das analoge Differenzsignal so zu integrieren, daß ein analoges Ausgangssignal erzeugt wird,
    - einen Rückkopplungsschaltkreis, umfassend einen Sigma-Delta-Analog/Digital-Wandler (333), dazu bestimmt, das analoge Ausgangssignal in ein digitales Rückkopplungssignal umzuwandeln, und einen Schaltkreis zur Kombination von Signalen, dazu bestimmt, ein analoges Eingangssignal mit dem Rückkopplungssignal so zu kombinieren, daß das kombinierte Signal erzeugt wird.

## Fig.1

## Fig.2

Fig. 3

EP 0 631 395 B1

# Fig. 4

# Fig. 5

Fig. 6

Fig. 7

Fig.8

EP 0 631 395 B1

Fig.9

Fig.10

Fig.11

# Fig.12

Fig.12 — Xin, G(k), X (291), + (285), Z⁻¹ (284), 271, 292, G(k)/G(k-1), x, Xint, 282, Ylsb, Ymsb, Yout

# Fig.14

Xin, + (285), Z⁻¹ (284), 320, $X1 = Ylsb + Ymsb$, G, Ylsb, Ymsb, 321, Yout

Fig.13

EP 0 631 395 B1

## Fig.15

## Fig.16

## Fig.17